# EUROPEAN PATENT SPECIFICATION

(11) **EP 4 524 410 B1**
(45) Date of publication and mention of the grant of the patent: **19.08.2026**
(21) Application number: 23917245.5
(22) Date of filing: 05.12.2023
(51) Int. Cl.: F16C 11/04, G09F 9/30, H05K 5/02, H04M 1/02, G06F 1/16, F16C 29/02, F16C 29/00

(54) **SLIDING MECHANISM AND ELECTRONIC DEVICE**
SCHIEBEMECHANISMUS UND ELEKTRONISCHE VORRICHTUNG
MÉCANISME COULISSANT ET DISPOSITIF ÉLECTRONIQUE

(30) Priority: 19.01.2023 CN 202310090462
(43) Date of publication of application: 19.03.2025
(73) Proprietor: Honor Device Co., Ltd., Shenzhen, Guangdong 518040 (CN)
(72) Inventor: ZHU, Guocai, Shenzhen, Guangdong 518040 (CN); LI, Xiaorong, Shenzhen, Guangdong 518040 (CN); QIN, Hanwen, Shenzhen, Guangdong 518040 (CN)
(74) Representative: MERH-IP Matias Erny Reichl Hoffmann Patentanwälte PartG mbB
(86) International application number: PCT/CN2023/136549
(87) International publication number: WO 2024/152777

(56) References cited:
- CN-A- 111 649 087
- CN-A- 114 338 859
- CN-U- 205 991 058
- CN-U- 208 359 986
- CN-U- 213 820 564
- CN-U- 215 268 379

## Description

This application claims priority to Chinese Patent Application No. 202310090462.6, filed with the China National Intellectual Property Administration on January 19, 2023 and entitled "SLIDING MECHANISM AND ELECTRONIC DEVICE".

### TECHNICAL FIELD

This application relates to the field of electronic device technologies, and in particular, to a sliding mechanism and an electronic device.

### BACKGROUND

In electronic devices such as a foldable-screen mobile phone, a portable android device, and a notebook computer, there is a movable connection apparatus, and the movable connection apparatus is configured to implement a movable connection between at least two components in the electronic device. For example, when the electronic device is a foldable-screen mobile phone, the movable connection apparatus may be a rotating shaft apparatus connected between two housings, and the rotating shaft apparatus is configured to implement a rotary connection between the two housings.

In some application scenarios, the movable connection apparatus may include both a sliding mechanism and a damping mechanism. The sliding mechanism is configured to generate relative sliding to support movement of the movable connection apparatus, and the damping mechanism enables the movable connection apparatus to have a specific damping function when the movable connection apparatus moves. However, in a conventional technology, the damping mechanism and the sliding mechanism are usually disposed independently of each other in the movable connection apparatus. Consequently, a volume of the movable connection apparatus is relatively large, which is not conducive to thin and miniaturized design of the electronic device. CN 111 649 087 A discloses a variable-friction damping vibration isolator with an adjustable central position, wherein the variable-friction damping vibration isolator comprises a base, a snap ring, a friction guide rail, and an upper cover; the friction guide rail has a height-adjustment tapered surface, and the friction guide rail mates with the snap ring via the height-adjustment tapered surface; and the upper cover is pressed onto the friction guide rail.

### SUMMARY

This application provides a sliding mechanism and an electronic device, so that the sliding mechanism can have a damping function, which helps reduce occupied space of a movable connection apparatus and implement thinning or miniaturization of the electronic device.

The invention is directed to the subject-matter of the independent claim. Advantageous embodiments are set out in the dependent claims.

To achieve the foregoing objective, the following technical solutions are used in this application:
According to a first aspect, a sliding mechanism is provided. The sliding mechanism includes a sliding rail, a sliding member, and a damping assembly. An extension direction of the sliding rail is a first direction. The sliding member is in sliding fit with the sliding rail. The damping assembly includes a first elastic structure, a second elastic structure, a first concave-convex surface region, and a second concave-convex surface region. One of the first elastic structure and the first concave-convex surface region is disposed on the sliding rail and the other thereof is disposed on the sliding member, and the first elastic structure fits with the first concave-convex surface region. One of the second elastic structure and the second concave-convex surface region is disposed on the sliding rail and the other thereof is disposed on the sliding member, and the second elastic structure fits with the second concave-convex surface region.

On the basis of the above, the first concave-convex surface region and the second concave-convex surface region each include a plurality of concave surface portions spaced apart in the first direction, and a convex surface portion is formed between two adjacent concave surface portions. In a process in which the sliding member slides relative to the sliding rail, when the first elastic structure fits with the concave surface portion of the first concave-convex surface region, the second elastic structure fits with a convex surface portion of the second concave-convex surface region; and when the first elastic structure fits with a convex surface portion of the first concave-convex surface region, the second elastic structure fits with the concave surface portion of the second concave-convex surface region.

In this way, when the sliding member slides relative to the sliding rail, the first elastic structure slides along the first concave-convex surface region, and the second elastic structure slides along the second concave-convex surface region. In addition, when the first elastic structure fits with the concave surface portion, the second elastic structure fits with the convex surface portion, and when the first elastic structure fits with the convex surface portion, the second elastic structure fits with the concave surface portion. On the basis of this, when the first elastic structure and the second elastic structure fit with the concave surface portions, an elastic force exerted on a first side surface is relatively small, and a friction force F_{friction} is relatively small, and may even be zero; and when the first elastic structure and the second elastic structure fit with the convex surface portions, the elastic force exerted on the first side surface is relatively large, and the friction force F_{friction} is relatively large. Therefore, the alternate fitting can improve continuity and stability of the friction force F_{friction}. When the sliding mechanism is applied to a movable connection apparatus in an electronic device, there is no need to additionally dispose a damping mechanism. Therefore, occupied space of the movable connection apparatus can be reduced, which is conducive to thinning or miniaturization of the electronic device.

In a possible implementation of the first aspect, a distance between two adjacent concave surface portions of the first concave-convex surface region is equal to a distance between two adjacent concave surface portions of the second concave-convex surface region. The distance between two adjacent concave surface portions of the first concave-convex surface region and the second concave-convex surface region is a first distance D₁, and a distance between the first elastic structure and the second elastic structure in the first direction is a second distance D₂. The first concave-convex surface region and the second concave-convex surface region are arranged in alignment with each other in the first direction, and the second distance D₂ meets a condition: D₂=(K+1/2)×D₁. K is 0 or a positive integer greater than 0. In this arrangement manner, in the process in which the sliding member slides relative to the sliding rail, when the first elastic structure fits with the concave surface portion of the first concave-convex surface region, the second elastic structure fits with the convex surface portion of the second concave-convex surface region; and when the first elastic structure fits with the convex surface portion of the first concave-convex surface region, the second elastic structure fits with the concave surface portion of the second concave-convex surface region. This arrangement manner is simple and easy to operate.

In a possible implementation of the first aspect, the sliding rail is provided with a sliding groove, the sliding groove includes a first inner surface, and the first inner surface is parallel to the first direction. At least a part of the sliding member is in sliding fit with the sliding groove, the at least a part includes a first side surface, and the first side surface and the first inner surface face each other. The sliding rail includes a first limiting portion, the first limiting portion is located on a side that is of the first inner surface and that is away from the first side surface, and the first inner surface is formed on the first limiting portion. On the basis of this, the first elastic structure and the second elastic structure are disposed on the first limiting portion, and the first concave-convex surface region and the second concave-convex surface region are disposed on the first side surface; or the first elastic structure and the second elastic structure are disposed on the at least a part, and the first concave-convex surface region and the second concave-convex surface region are disposed on the first inner surface. In this arrangement manner, the first elastic structure and the second elastic structure are arranged on a same component, and the first concave-convex surface region and the second concave-convex surface region are arranged on a same surface. This arrangement manner facilitates material selection of the sliding member and the sliding rail. Specifically, a material with relatively large hardness and relatively good wear resistance performance may be selected to produce a component on which the first concave-convex surface region and the second concave-convex surface region are disposed, and a material with relatively low costs may be selected to produce the component on which the first elastic structure and the second elastic structure are disposed. Therefore, operations are easy, and costs can be reduced.

In a possible implementation of the first aspect, the first concave-convex surface region and the second concave-convex surface region are spaced apart in a second direction, the second direction is perpendicular to the first direction, and the second direction is parallel to the first side surface. The first elastic structure and the second elastic structure are spaced apart in the second direction. In this way, when the sliding member slides relative to the sliding rail, friction forces are staggered in the second direction, so that uniform distribution and stability of the friction forces can be ensured. In addition, the first elastic structure and the second elastic structure are respectively in contact and friction with different concave-convex surface regions, so that wear can be reduced.

In a possible implementation of the first aspect, there are a plurality of first elastic structures, and the plurality of first elastic structures are successively arranged in the first direction; and all of the plurality of first elastic structures fit with the concave surface portions of the first concave-convex surface region, or all of the plurality of first elastic structures fit with convex surface portions of the first concave-convex surface region. There are a plurality of second elastic structures, and the plurality of second elastic structures are successively arranged in the second direction; and all of the plurality of second elastic structures fit with convex surface portions of the second concave-convex surface region, or all of the plurality of second elastic structures fit with the concave surface portions of the second concave-convex surface region. In the process in which the sliding member slides relative to the sliding rail, when the plurality of first elastic structures fit with the concave surface portions of the first concave-convex surface region, the plurality of second elastic structures fit with the convex surface portions of the second concave-convex surface region; and when the plurality of first elastic structures fit with the convex surface portions of the first concave-convex surface region, the plurality of second elastic structures fit with the concave surface portions of the second concave-convex surface region. In this way, the plurality of first elastic structures and second elastic structures are disposed, so that a combined elastic force can be increased, thereby increasing a total friction force and improving a damping function of the damping assembly.

In a possible implementation of the first aspect, a distance between two adjacent first elastic structures is a third distance D₃, and the third distance D₃ meets a condition: D₃=E×D₁. A distance between two adjacent second elastic structures is a fourth distance D₄, and the fourth distance D₄ meets a condition: D₄=F×D₁. E and F are positive integers greater than 0. In this way, it can be ensured that all of the plurality of first elastic structures 31 fit with the concave surface portions a of the first concave-convex surface region 33, or all of the plurality of first elastic structures 31 fit with the convex surface portions b of the first concave-convex surface region 33, and it can also be ensured that all of the plurality of second elastic structures 32 fit with the convex surface portions b of the second concave-convex surface region 34, or all of the plurality of second elastic structures 32 fit with the concave surface portions a of the second concave-convex surface region 34.

In a possible implementation of the first aspect, the plurality of concave surface portions of the first concave-convex surface region are respectively aligned with and connected to the plurality of concave surface portions of the second concave-convex surface region to form an integral concave surface portion, and the plurality of convex surface portions of the first concave-convex surface region are respectively aligned with and connected to the plurality of convex surface portions of the second concave-convex surface region to form an integral convex surface portion. In this way, surfaces on which the first concave-convex surface region and the second concave-convex surface region are located are simple in profile and are easy to machine.

In a possible implementation of the first aspect, the first concave-convex surface region and the second concave-convex surface region are a same concave-convex surface region, and the first elastic structure and the second elastic structure are arranged in a row in the first direction. In this way, the first elastic structure and the second elastic structure fit with a same concave-convex surface region. This structure is simple, and machining costs are relatively low.

On the basis of the above, optionally, there is at least one first elastic structure, there is at least one second elastic structure, and the at least one first elastic structure and the at least one second elastic structure are successively alternately arranged in the first direction. In this way, a quantity of first elastic structures and a quantity of second elastic structures can be increased, to increase the combined elastic force, so that the total friction force can be increased, and the damping function of the damping assembly can be improved.

In a possible implementation of the first aspect, the first elastic structure is disposed on the first limiting portion, and the first concave-convex surface region is disposed one the first side surface. The first elastic structure includes a base, a first pressing member, and a first elastic member. The base is disposed on the first limiting portion, the base is provided with a sliding hole, one end of the sliding hole is closed to form a closed end, the other end of the sliding hole is opened to form an open end, and the open end is located on a side that is of the closed end and that faces the first concave-convex surface region. The first pressing member is disposed in the sliding hole and is capable of sliding along the sliding hole, and a part of the first pressing member projects from the open end. The first elastic member is disposed in the sliding hole and is located between the closed end and the first pressing member, and the part that is of the first pressing member and that projects from the open end fits with the first concave-convex surface region. In this structure, an elastic force is provided by using the first elastic member, the first pressing member is used for contact and friction with the first concave-convex surface region, the first elastic member may be produced by using a structure with a stable elastic force, and the first pressing member may be produced by using a material with relatively good wear resistance performance. The arrangement is suitable, and can prolong a service life of the first elastic structure. In addition, both the first pressing member and the first elastic member are fastened to the base. In this way, the first elastic structure can be used as an independent product and assembled with the first limiting portion, so that assembly efficiency of the sliding mechanism can be improved.

In a possible implementation of the first aspect, the first limiting portion is provided with a first threaded hole, and an end of the first threaded hole penetrates the first inner surface. A first external thread is disposed on an outer circumference of the base, an axial direction of the first external thread is parallel to an axial direction of the sliding hole, the base is accommodated in the first threaded hole, and the first external thread is in threaded fit with the first threaded hole. In this way, the base is rotated in the first threaded hole, to adjust a position of the first elastic structure in the axial direction of the first threaded hole, so that an elastic force of the first elastic structure is adjusted. In addition, after the first pressing member is worn, the service life of the first elastic structure can be prolonged by adjusting the position of the first elastic structure.

In a possible implementation of the first aspect, the base includes a base body and a fastening member. The first external thread and the sliding hole are disposed on the base body, the base body is further provided with an inner hole, the inner hole is located on a side that is of the closed end and that is away from the open end, the inner hole and the sliding hole are coaxially disposed and communicate with each other, and an end that is of the inner hole and that is away from the sliding hole penetrates the base body. The fastening member is disposed in the inner hole. In this way, the first pressing member and the first elastic member can be installed in the sliding hole from the inner hole, and then the fastening member is assembled in the inner hole. Therefore, assembly of the first pressing member and the first elastic member is implemented. This assembly manner is simple and easy to operate.

In a possible implementation of the first aspect, the inner hole is a second threaded hole, a second external thread is disposed on an outer circumference of the fastening member, and the second external thread is in threaded fit with the second threaded hole. In this way, the inner hole is threadedly connected to the inner hole. This connection manner is simple and can implement disassembly. After the first pressing member is worn, the first pressing member can be easily replaced, so that maintenance costs of the first elastic structure can be reduced.

In a possible implementation of the first aspect, the first limiting portion further includes a first outer surface, the first outer surface and the first inner surface face away from each other, and the first threaded hole penetrates the first outer surface. An end surface that is of the fastening member and that is away from the sliding hole is provided with an operating slot, and the operating slot is a non-circular slot. In this way, an assembly person holds an operating tool and enables the operating tool to engage with the operating slot, to drive the first elastic structure to rotate, so that the first elastic structure is installed in the first threaded hole through an opening at an end that is of the first threaded hole and that penetrates the first outer surface. In addition, an adjustment to the position of the first elastic structure in the first threaded hole can be further implemented by using the operating tool, so that the elastic force of the first elastic structure is adjusted. The installation and adjustment operations are easy.

In a possible implementation of the first aspect, rotation directions of the first external thread and the second external thread are opposite to each other. In this way, when the first elastic structure is installed or adjusted by using the operating tool, detachment of the fastening member from the base body can be avoided, so that structural stability of the first elastic structure can be ensured.

In a possible implementation of the first aspect, the first pressing member is a ball plunger, an ejector pin, or a pressing block.

In a possible implementation of the first aspect, the first elastic structure is disposed on the at least a part, and the first concave-convex surface region is disposed on the first inner surface. The at least a part further includes a second side surface, the second side surface and the first side surface face away from each other, the sliding groove further includes a second inner surface, and the second inner surface and the second side surface face each other. The first elastic structure includes a base, a second pressing member, a third pressing member, and a second elastic member. The base is disposed on the at least a part, the base is provided with a sliding hole, one end of the sliding hole is opened to form a first open end, the other end of the sliding hole is opened to form a second open end, the first open end faces the first inner surface, and the second open end faces the second inner surface. The second pressing member is disposed in the sliding hole and is capable of sliding along the sliding hole, and a part of the second pressing member projects from the first open end. The third pressing member is disposed in the sliding hole and is capable of sliding along the sliding hole, and a part of the third pressing member projects from the second open end. The second elastic member is disposed in the sliding hole and is located between the second pressing member and the third pressing member, the second pressing member fits with the first concave-convex surface region, and the third pressing member fits with the second inner surface. In this structure, an elastic force is provided by using the second elastic member, the second pressing member is used for contact and friction with the first concave-convex surface region, the third pressing member is used for contact and friction with the second inner surface, the second elastic member may be produced by using a structure with a stable elastic force, and the second pressing member and the third pressing member may be produced by using a material with relatively good wear resistance performance. The arrangement is suitable, and can prolong a service life of the first elastic structure. In addition, all of the second pressing member, the third pressing member, and the second elastic member are fastened to the base. In this way, the first elastic structure can be used as an independent product and assembled with the sliding member, so that assembly efficiency of the sliding mechanism can be improved.

In a possible implementation of the first aspect, the damping assembly further includes a third concave-convex surface region. The third concave-convex surface region is disposed on the second inner surface, the third concave-convex surface region includes a plurality of concave surface portions spaced apart in the first direction, and a convex surface portion is formed between two adjacent concave surface portions. A distance between two adjacent concave surface portions of the third concave-convex surface region is equal to the distance between two adjacent concave surface portions of the first concave-convex surface region, and the third concave-convex surface region and the first concave-convex surface region are arranged in alignment with each other in the first direction. The third pressing member specifically fits with the third concave-convex surface region on the second inner surface. In this way, in the damping assembly, in addition to generating a friction force through fitting between the first elastic structure and the first concave-convex surface region, a friction force is generated through fitting between the first elastic structure and the third concave-convex surface region, so that a damping function of the damping assembly can be further improved. In addition, two opposite sides of the sliding member are subjected to friction forces at the same time. In the process of sliding relative to the sliding rail, the sliding member has relatively good stability, to prevent the sliding member from being tilted or even stuck.

In a possible implementation of the first aspect, the concave surface portion is a concave spherical surface, a concave arc surface, an inverted cone-shaped surface, or an inverted cone frustum surface whose side surface is an inclined surface and whose bottom surface is a flat surface.

In a possible implementation of the first aspect, surface roughness of the concave surface portion is greater than or equal to 0.2 and less than or equal to 0.6. Surface roughness of the convex surface portion is greater than or equal to 0.1 and less than or equal to 0.3. In this way, roughness of the first concave-convex surface region and the second concave-convex surface region is moderate, thereby facilitating application in a 3C product.

In a possible implementation of the first aspect, a distance between two adjacent concave surface portions of the first concave-convex surface region is equal to a distance between two adjacent concave surface portions of the second concave-convex surface region. The distance between two adjacent concave surface portions of the first concave-convex surface region and the second concave-convex surface region is a first distance D₁, and a distance between the first elastic structure and the second elastic structure in the first direction is a second distance D₂. The second distance D₂ meets a condition: D₂=M×D₁, the first concave-convex surface region and the second concave-convex surface region are arranged in a staggered manner in the first direction, and a staggering amount D_{d} between the first concave-convex surface region and the second concave-convex surface region meets a condition: Da=(N+1/2)×D₁. In this way, in the process in which the sliding member slides relative to the sliding rail, when the first elastic structure fits with the concave surface portion, the second elastic structure fits with the convex surface portion, and when the first elastic structure fits with the convex surface portion, the second elastic structure fits with the concave surface portion. Therefore, the alternate fitting can also improve continuity and stability of the friction force F_{friction}. This arrangement manner is simple and easy to implement.

According to a second aspect, an electronic device is further provided. The electronic device includes a first component, a second component, and a movable connection apparatus, the movable connection apparatus is connected between the first component and the second component, and the movable connection apparatus includes the sliding mechanism described in any one of the foregoing technical solutions.

Because the movable connection apparatus in the electronic device provided in this application includes the sliding mechanism described in any one of the foregoing technical solutions, a volume of the movable connection apparatus can be reduced, which is conducive to thinning and miniaturization of the electronic device.

In a possible implementation of the second aspect, the electronic device is a foldable-screen terminal, and the foldable-screen terminal includes a first housing, a second housing, and a rotating shaft apparatus connected between the first housing and the second housing. The first housing forms the first component, the second housing forms the second component, and the rotating shaft apparatus forms the movable connection apparatus. In this way, a volume of the rotating shaft apparatus is conveniently reduced, which is conducive to thinning and miniaturization of the foldable-screen terminal.

### BRIEF DESCRIPTION OF DRAWINGS

FIG. 1 is a three-dimensional view of a foldable-screen terminal according to some embodiments of this application;
FIG. 2 is a schematic diagram of an exploded structure of the foldable-screen terminal shown in FIG. 1;
FIG. 3 is a three-dimensional view of the foldable-screen terminal shown in FIG. 1 and FIG. 2 in a folded state;
FIG. 4 is a schematic diagram of a cross-sectional structure of the foldable-screen terminal shown in FIG. 3 in a direction A-A;
FIG. 5 is a partially enlarged view of a region I in the foldable-screen terminal shown in FIG. 4;
FIG. 6 is a three-dimensional view of a sliding mechanism according to some embodiments of this application;
FIG. 7 is a schematic diagram of a structure existing when the sliding mechanism shown in FIG. 6 is fastened to a connecting member;
FIG. 8 is a three-dimensional view existing after a sliding rail is hidden from the sliding mechanism shown in FIG. 6;
FIG. 9 is a three-dimensional view of a first elastic structure in the sliding mechanism shown in FIG. 8;
FIG. 10 is a three-dimensional cross-sectional view of the first elastic structure shown in FIG. 9;
FIG. 11 is a partial cross-sectional view, at a first elastic structure, of the sliding mechanism shown in FIG. 6;
FIG. 12 is a schematic diagram of a structure, at a first side surface, of a sliding member in the sliding mechanism shown in FIG. 8;
FIG. 13 is a schematic diagram of a relative position between the structure shown in FIG. 12 and a first elastic structure and a relative position between the structure shown in FIG. 12 and a second elastic structure;
FIG. 14 is a schematic diagram of a structure existing after a sliding member in the structure shown in FIG. 13 moves by a specific distance in a direction M relative to a first elastic structure and a second elastic structure;
FIG. 15 is a three-dimensional view existing after a sliding rail is hidden from a sliding mechanism according to some other embodiments of this application;
FIG. 16 is a schematic diagram of a structure, at a first side surface, of the structure shown in FIG. 15;
FIG. 17 is a three-dimensional view existing after a sliding rail is hidden from a sliding mechanism according to some other embodiments of this application;
FIG. 18 is a three-dimensional view of the sliding mechanism shown in FIG. 17 from another perspective;
FIG. 19 is a three-dimensional view existing after a sliding rail is hidden from a sliding mechanism according to some other embodiments of this application;
FIG. 20 is a three-dimensional view existing after a sliding rail is hidden from a sliding mechanism according to some other embodiments of this application;
FIG. 21 is a three-dimensional view existing after a sliding rail is hidden from a sliding mechanism according to some other embodiments of this application;
FIG. 22 is a three-dimensional view existing after a sliding rail is hidden from a sliding mechanism according to some other embodiments of this application;
FIG. 23 is a three-dimensional view existing after a sliding rail is hidden from a sliding mechanism according to some other embodiments of this application;
FIG. 24 is a three-dimensional view of a sliding mechanism according to some other embodiments of this application;
FIG. 25 is a three-dimensional view existing after a sliding member is hidden from the sliding mechanism shown in FIG. 24;
FIG. 26 is a three-dimensional view of a first elastic structure in the sliding mechanism shown in FIG. 25;
FIG. 27 is a three-dimensional cross-sectional view of the first elastic structure shown in FIG. 26;
FIG. 28 is a three-dimensional view of the sliding mechanism shown in FIG. 25 from another perspective; and
FIG. 29 is a schematic diagram of a relative position between a sliding member and a first elastic structure and a relative position between the sliding member and a second elastic structure in a sliding mechanism according to some other embodiments of this application.

### DESCRIPTION OF EMBODIMENTS

In the embodiments of this application, the terms "first", "second", and "third" are used merely for the purpose of description, and cannot be construed as indicating or implying relative importance or implicitly indicating a quantity of indicated technical features. Therefore, a feature defined with "first", "second", or "third" may explicitly or implicitly include one or more such features.

In the embodiments of this application, the term "include", "comprise", or any other variant thereof is intended to cover non-exclusive inclusion, so that a process, a method, an article, or an apparatus that includes a series of elements not only includes those elements, but also includes other elements that are not explicitly listed, or includes elements inherent to such a process, a method, an article, or an apparatus. Without further limitation, an element defined by the sentence "including a..." does not exclude existence of other identical elements in the process, method, article, or apparatus including the element.

In the embodiments of this application, unless otherwise noted, description of "parallel" represents that being approximately parallel within a specific error range is allowed, and the error range may be a range of a deviation angle of 5° or fewer relative to being absolutely parallel. Description of "perpendicular" represents that being approximately perpendicular within a specific error range is allowed, and the error range may be a range of a deviation angle of 5° or fewer relative to being absolutely perpendicular.

This application provides an electronic device. The electronic device may be user equipment (user equipment, UE), a terminal (terminal) device, or the like. For example, the electronic device may be a mobile terminal or a fixed terminal, for example, a portable android device (portable android device, PAD), a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home).

The electronic device includes a movable connection apparatus, and the movable connection apparatus is configured to implement a movable connection between a plurality of components in the electronic device. For example, the movable connection apparatus is connected between a first component and a second component, to implement a movable connection between the first component and the second component. The movable connection apparatus includes both a sliding mechanism and a damping mechanism. The sliding mechanism is configured to generate relative sliding to support movement of the movable connection apparatus. The damping mechanism enables the movable connection apparatus to have a specific damping function when the movable connection apparatus moves.

The following describes an application scenario and a specific structure implementation of the movable connection apparatus and the sliding mechanism and the damping mechanism in the movable connection apparatus by using an example in which the electronic device is a foldable-screen terminal. The foldable-screen terminal includes but is not limited to a 3C product such as a handheld smartphone, a PAD, a PDA, or a personal computer (personal computer, PC).

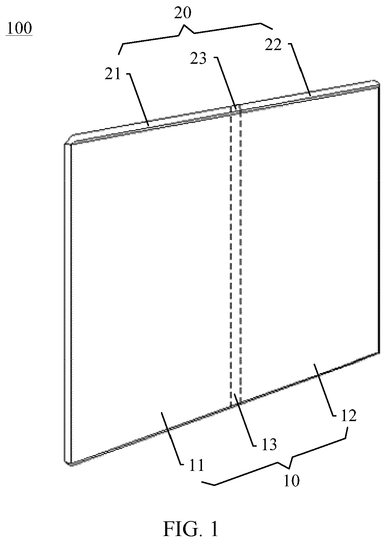

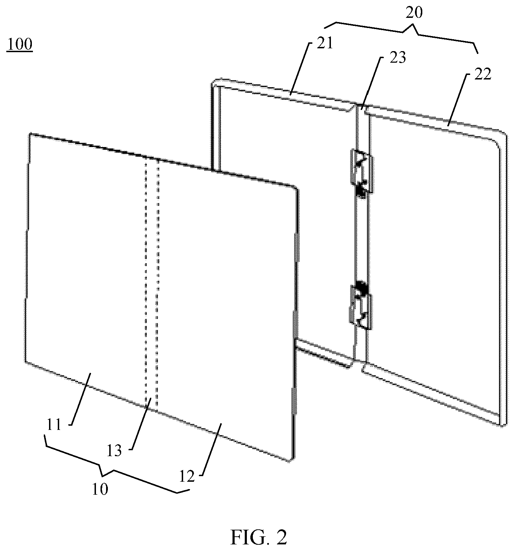

Specifically, referring to FIG. 1 and FIG. 2, FIG. 1 is a three-dimensional view of a foldable-screen terminal 100 according to some embodiments of this application, and FIG. 2 is a schematic diagram of an exploded structure of the foldable-screen terminal 100 shown in FIG. 1. In FIG. 1 and FIG. 2, the foldable-screen terminal 100 is in an unfolded state, and the foldable-screen terminal 100 is approximately in a shape of a rectangular flat panel in the unfolded state. In some other embodiments, the foldable-screen terminal 100 may alternatively be in a shape of a square flat panel, a shape of a round flat panel, a shape of an elliptical flat panel, or the like.

The foldable-screen terminal 100 includes a foldable screen 10 and a support apparatus 20.

The foldable screen 10 is configured to display information such as an image and a video. The foldable screen 10 may be an organic light-emitting diode (organic light-emitting diode, OLED) screen, a micro organic light-emitting diode (micro organic light-emitting diode) screen, a quantum dot light emitting diode (quantum dot light emitting diode, QLED) screen, a liquid crystal display (liquid crystal display, LCD), or the like.

The foldable screen 10 has a display region used to display image information, and the display region of the foldable screen 10 is exposed, to present information such as an image and a video to a user. The foldable screen 10 includes a first foldable screen part 11, a second foldable screen part 12, and a third foldable screen part 13. The third foldable screen part 13 is connected between the first foldable screen part 11 and the second foldable screen part 12. When the foldable screen 10 is in an unfolded state, the first foldable screen part 11, the third foldable screen part 13, and the second foldable screen part 12 are arranged in a row and flush with each other, so that large-screen display can be implemented, to provide richer information for the user and bring better use experience to the user.

At least the third foldable screen part 13 of the foldable screen 10 is of a flexible screen structure. In this way, the third foldable screen part 13 may be bent and deformed after being subjected to an external force, so that the foldable screen 10 is folded from the unfolded state shown in FIG. 1 to a folded state. The first foldable screen part 11 and the second foldable screen part 12 of the foldable screen 10 each may be of a flexible screen structure, or may be of a rigid screen structure, or may be partially of a flexible screen structure and partially of a rigid screen structure. This is not specifically limited herein.

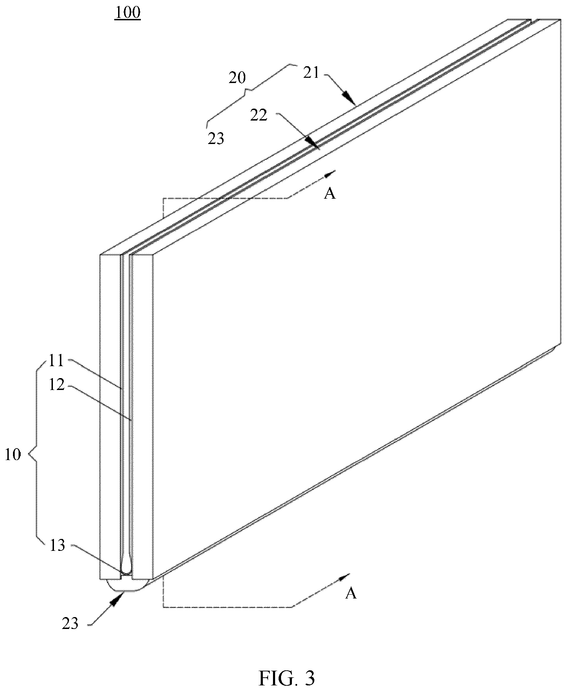

Referring to FIG. 3, FIG. 3 is a three-dimensional view of the foldable-screen terminal 100 shown in FIG. 1 and FIG. 2 in a folded state. When the foldable-screen terminal 100 is in the folded state, the foldable screen 10 is also in the folded state. In this state, the first foldable screen part 11 and the second foldable screen part 12 of the foldable screen 10 are approximately parallel to each other and opposite to each other. It should be noted that an included angle between the first foldable screen part 11 and the second foldable screen part 12 is within 30°, and both the first foldable screen part 11 and the second foldable screen part 12 may be considered approximately parallel to each other. That the first foldable screen part 11 and the second foldable screen part 12 are opposite to each other means that a display surface of the first foldable screen part 11 and a display surface of the second foldable screen part 12 face each other. The third foldable screen part 13 is in a bent state.

When the foldable-screen terminal 100 is in the folded state, still referring to FIG. 3, the support apparatus 20 is located outside the foldable screen 10 for protection, and the foldable screen 10 is invisible to the user, so that the foldable screen 10 can be prevented from being scratched by a hard object. A size of the foldable-screen terminal 100 is reduced, so that the foldable-screen terminal 100 is easy to carry.

The support apparatus 20 is configured to bear the foldable screen 10. The support apparatus 20 includes a first housing (which may also be referred to as a primary housing) 21, a second housing (which may also be referred to as a secondary housing) 22, and a rotating shaft apparatus 23. The first foldable screen part 11 is disposed on the first housing 21, and the second foldable screen part 12 is disposed on the second housing 22. The rotating shaft apparatus 23 is connected between the first housing 21 and the second housing 22, and the third foldable screen part 13 is disposed on the rotating shaft apparatus 23. The first housing 21 forms the foregoing first component, the second housing 22 forms the foregoing second component, and the shaft rotating apparatus 23 forms the foregoing movable connection apparatus. The rotating shaft apparatus 23 is configured to implement rotation between the second housing 22 and the first housing 21, to support folding of the foldable screen 10 between the unfolded state and the folded state.

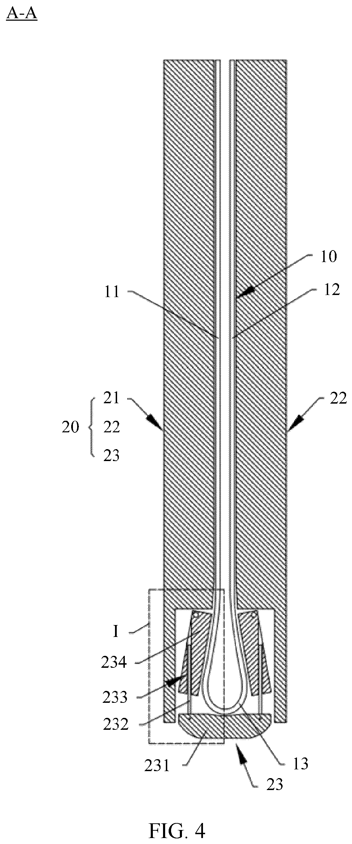

Referring to FIG. 4, FIG. 4 is a schematic diagram of a cross-sectional structure of the foldable-screen terminal 100 shown in FIG. 3 in a direction A-A. The rotating shaft apparatus 23 includes a rotating shaft base 231, a sliding swing arm 232, a sliding mechanism 233, and a connecting member 234.

The rotating shaft base 231 (which may also be referred to as a middle beam) provides a position reference in the rotating shaft apparatus 23. The first housing 21 is rotatably connected to the rotating shaft base 231, and the first housing 21 can rotate relative to the rotating shaft base 231, so that the foldable-screen terminal 100 moves between the unfolded state and the folded state. In addition, the rotating shaft base 231 is further configured to support a part of the foldable screen. Specifically, the rotating shaft base 231 is configured to support a part of the third foldable screen part 13 of the foldable screen 10 in the electronic device shown in FIG. 4. The connecting member 234 is configured to support the other part of the third foldable screen part 13.

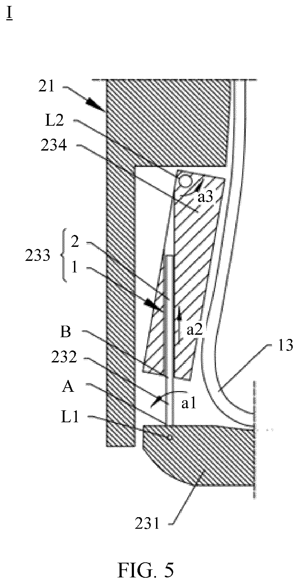

Referring to FIG. 5, FIG. 5 is a partially enlarged view of a region I in the foldable-screen terminal 100 shown in FIG. 4. The sliding swing arm 232 has a first end A and a second end B that are opposite to each other, the first end A is rotatably connected to the rotating shaft base 231, and a rotation axis of the first end A on the rotating shaft base 231 is a first axis L1.

The sliding mechanism 233 is connected between the second end B and the connecting member 234, and is configured to implement relative sliding between the second end B and the connecting member 234, to support movement of the rotating shaft apparatus 23 between a folded state and an unfolded state. The sliding mechanism 233 includes a sliding rail 1 and a sliding member 2. The sliding rail 1 may be a sliding groove-type sliding rail, the sliding groove-type sliding rail is disposed on the connecting member 234, the sliding member 2 may be a sliding rod, and the sliding rod is disposed on the second end B. In another embodiment, positions of the sliding rail 1 and the sliding member 2 are interchangeable, and the sliding rail 1 and the sliding member 2 may have another structural form. An extension direction of the sliding rail 1 is perpendicular to the first axis L1, and the sliding member 2 is in sliding fit with the sliding rail 1.

The connecting member 234 is connected to the first housing 21. Specifically, the connecting member 234 and the first housing 21 may be fixedly connected to each other, or may be movably connected to each other, and may be directly connected to each other, or may be indirectly connected by using another intermediate structure. This is not specifically limited herein. A movable connection manner includes but is not limited to at least one of a rotary connection or a sliding connection. When the connecting member 234 and the first housing 21 are directly connected to each other, the connecting member 234 and the housing 21 may be in direct contact with and fastened to each other, or may be rotatably connected to each other through fitting of a rotating pair, or may be slidably connected to each other through fitting of a sliding pair. When the connecting member 234 and the first housing 21 are indirectly connected to each other by using another intermediate structure, there may be one or more intermediate structures. The intermediate structures, the intermediate structure and the connecting member 234, and the intermediate structure and the first housing 21 may be fixedly connected to each other, or may be movably connected to each other. This is not specifically limited herein. FIG. 5 provides descriptions by using an example in which the connecting member 234 and the first housing 21 are rotatably connected each other. In the embodiment shown in FIG. 5, a rotation axis of the connecting member 234 relative to the first housing 21 is a second axis L2.

It should be noted that FIG. 5 schematically shows some components included in the rotating shaft apparatus 23, and actual shapes, actual sizes, actual positions, and actual composition of these components are not limited by FIG. 5. In addition, in addition to these components, the rotating shaft apparatus 23 may include another component such as a main swing arm, a shaft cover, or a lifting plate.

When the foldable-screen terminal 100 switches between the folded state and the unfolded state, a movement manner of each moving component (including the sliding swing arm 232, the sliding mechanism 233, and the connecting member 234) in the rotating shaft apparatus 23 is unique, so that movement stability of the rotating shaft apparatus 23 can be ensured.

For example, the unique movement manner of the sliding swing arm 232, the sliding mechanism 233, and the connecting member 234 in the rotating shaft apparatus 23 may be as follows: When the foldable-screen terminal 100 switches from the folded state shown in FIG. 3 to the unfolded state shown in FIG. 1, the sliding swing arm 232 may rotate in a direction a1 relative to the rotating shaft base 231, the sliding member 2 slides in a direction a2 relative to the sliding rail 1, and the connecting member 234 rotates in a direction a3 relative to the first housing 21, so that the foldable screen 10 supported on the rotating shaft base 231, the connecting member 234, and the first housing 21 is unfolded. When the foldable-screen terminal 100 moves from the folded state shown in FIG. 1 to the unfolded state shown in FIG. 3, the sliding swing arm 232 may rotate in a direction opposite to the direction a1 relative to the rotating shaft base 231, the sliding member 2 slides in a direction opposite to the direction a2 relative to the sliding rail 1, and the connecting member 234 rotates in a direction opposite to the direction a3 relative to the first housing 21, so that the foldable screen 10 supported on the rotating shaft base 231, the connecting member 234, and the first housing 21 is folded.

On the basis of the above, the rotating shaft apparatus 23 further includes a damping mechanism (not shown in the figure). The damping mechanism is configured to enable the rotating shaft apparatus 23 to have a specific damping force when moving between the folded state and the unfolded state, so that the foldable-screen terminal 100 can remain in the folded state, the unfolded state, and one or more semi-folded states between the folded state and the unfolded state. In addition, the damping mechanism can achieve a specific folding hand feel, which can provide better use experience to the user.

In the rotating shaft apparatus 23, the damping mechanism and the sliding mechanism 233 are usually disposed independently of each other. For example, referring to FIG. 5, the sliding mechanism 233 is disposed between the sliding swing arm 232 and the connecting member 234, and the damping mechanism may be disposed between the sliding swing arm 232 (or another swing arm) and the rotating shaft base 231. A specific structural form of the damping mechanism includes but is not limited to an elastic cam mechanism and a friction damping mechanism, so that there is a specific damping force for rotation of the swing arm relative to the rotating shaft base 231. On the basis of this, because the movement manner of each moving component in the rotating shaft apparatus 23 is unique, the rotating shaft apparatus 23 can have a damping function. In this way, the rotating shaft apparatus 23 is relatively large in volume, and occupies relatively large space in the foldable-screen terminal 100, which is not conducive to thin and miniaturized design of the foldable-screen terminal 100.

To avoid the foregoing problem, this application provides a sliding mechanism. A damping assembly is integrated into the sliding mechanism, and the damping assembly has a damping function. When the sliding mechanism is applied to a rotating shaft apparatus 23, because a movement form of the rotating shaft apparatus 23 is unique, the rotating shaft apparatus 23 can have a damping function. Occupied space of the rotating shaft apparatus 23 can be reduced, which is conducive to thinning and miniaturization of a foldable-screen terminal 100.

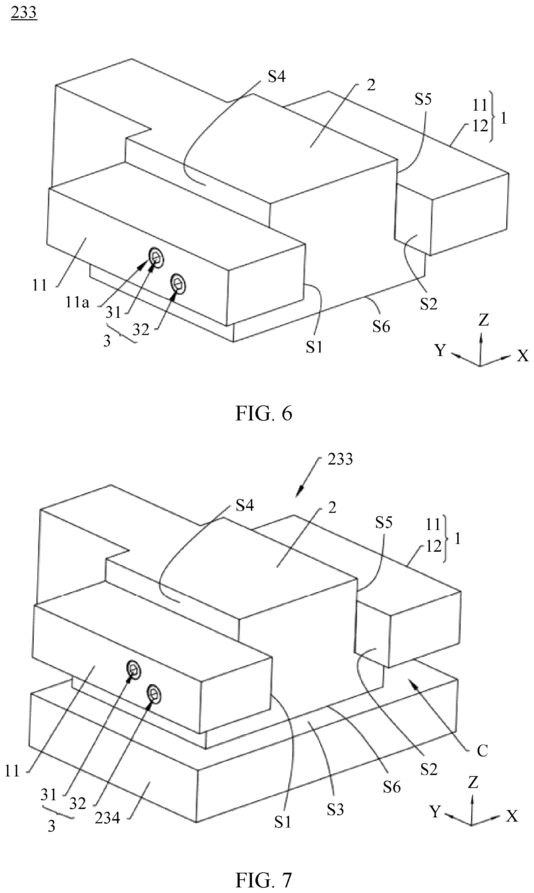

Specifically, referring to FIG. 6, FIG. 6 is a three-dimensional view of a sliding mechanism 233 according to some embodiments of this application. The sliding mechanism 233 includes a sliding rail 1, a sliding member 2, and a damping assembly 3. For ease of description in the following embodiments, an XYZ coordinate system is established, a length direction (also referred to as an extension direction) of the sliding rail 1 in the sliding mechanism 233 is defined as a Y-axis direction, a width direction of the sliding rail 1 is defined as an X-axis direction, and a height direction of the sliding rail 1 is defined as a Z-axis direction. It may be understood that the coordinate system for the sliding mechanism 233 may be flexibly set based on an actual need. This is not specifically limited herein.

The extension direction of the sliding rail 1 is a first direction (namely, the Y-axis direction). The sliding rail 1 may be a sliding groove-type sliding rail, or may be a saddle-type sliding rail. In the embodiment shown in FIG. 6, the sliding rail 1 is a sliding groove-type sliding rail. Specifically, the sliding rail 1 includes a first limiting portion 11 and a second limiting portion 12 that are spaced apart in the X-axis direction. When the sliding mechanism 233 is fastened to the foregoing connecting member 234, reference is made to FIG. 7. FIG. 7 is a schematic diagram of a structure existing when the sliding mechanism 233 shown in FIG. 6 is fastened to the connecting member 234. A relative position between the first limiting portion 11 and the connecting member 234 and a relative position between the second limiting portion 12 and the connecting member 234 are fixed, and a sliding groove C is enclosed by the first limiting portion 11, the second limiting portion 12, and the connecting member 234.

The sliding member 2 includes but is not limited to a sliding block, a sliding column, or a slider. FIG. 6 provides descriptions by using an example in which the sliding member 2 is a sliding block. The sliding member 2 is in sliding fit with the sliding rail 1. In the embodiment shown in FIG. 6, at least a part of the sliding member 2 is accommodated in the sliding groove C, and can slide in the sliding groove C in the first direction. In addition, the first limiting portion 11 and the second limiting portion 12 fit with the connecting member 234, to prevent the sliding member 2 from being detached from the sliding groove C.

Referring to FIG. 6 and FIG. 7 together, the sliding groove C has a first inner surface S1, a second inner surface S2, and a third inner surface S3 that are parallel to the first direction. The first inner surface S1 is located on the first limiting portion 11, the second inner surface S2 is located on the second limiting portion 12, and the third inner surface S3 is located on the connecting member 234.

The sliding member 2 includes a first side surface S4, a second side surface S5, and a third side surface S6. The first side surface S4 and the first inner surface S1 face each other, the second side surface S5 and the second inner surface S2 face each other, and the third side surface S6 and the third inner surface S3 face each other.

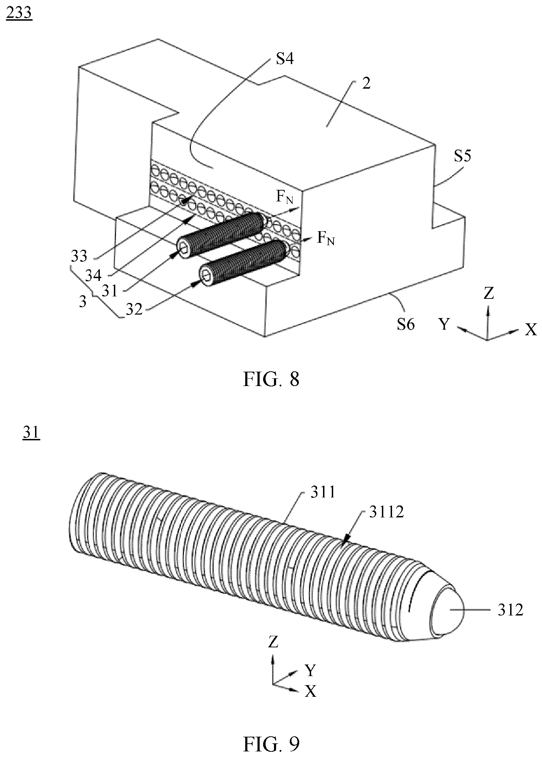

On the basis of the above, referring to FIG. 8, FIG. 8 is a three-dimensional view existing after the sliding rail 1 is hidden from the sliding mechanism 233 shown in FIG. 6. The damping assembly 3 is configured to apply a specific damping force to the sliding member 2 when the sliding member 2 slides relative to the sliding rail 1. The damping assembly 3 includes a first elastic structure 31, a second elastic structure 32, a first concave-convex surface region 33, and a second concave-convex surface region 34.

Referring to FIG. 6 and FIG. 8 together, the first elastic structure 31 and the second elastic structure 32 are disposed on the sliding rail 1, and the first concave-convex surface region 33 and the second concave-convex surface region 34 are disposed on the sliding member 2. Specifically, the first elastic structure 31 and the second elastic structure 32 may be disposed on the first limiting portion 11 in the sliding rail 1, and the first concave-convex surface region 33 and the second concave-convex surface region 34 may be disposed on the first side surface S4 of the sliding member 2. In this arrangement manner, the first elastic structure 31 and the second elastic structure 32 are arranged on a same component, and the first concave-convex surface region 33 and the second concave-convex surface region 34 are arranged on a same surface. This arrangement manner facilitates material selection of the sliding member and the sliding rail. Specifically, a material with relatively large hardness and relatively good wear resistance performance may be selected to produce the sliding member, and a material with relatively low costs may be selected to produce the sliding rail. Therefore, operations are easy, and costs can be reduced.

The first elastic structure 31 fits with the first concave-convex surface region 33, and the second elastic structure 32 fits with the second concave-convex surface region 34. When the sliding member 2 slides relative to the sliding rail 1, the first elastic structure 31 slides along the first concave-convex surface region 33, and the second elastic structure 32 slides along the second concave-convex surface region 34.

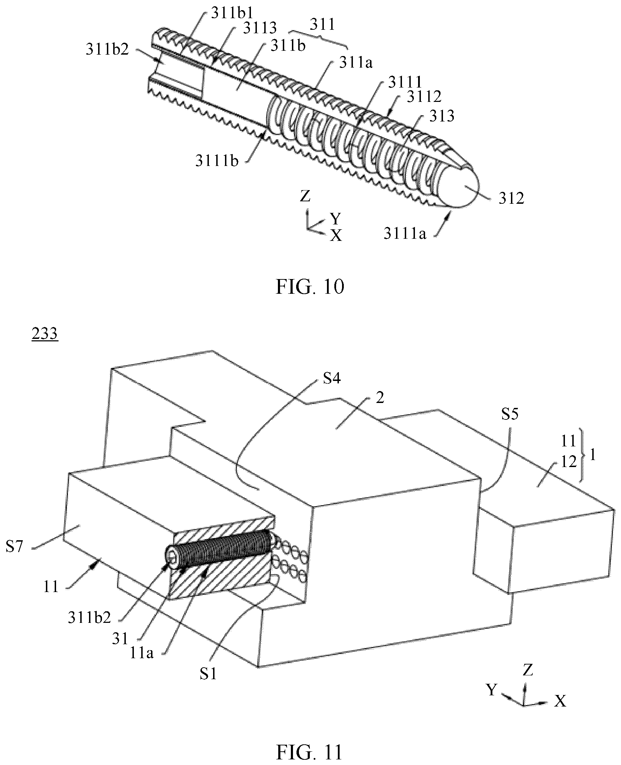

Referring to FIG. 9 and FIG. 10, FIG. 9 is a three-dimensional view of the first elastic structure 31 in the sliding mechanism 233 shown in FIG. 8, and FIG. 10 is a three-dimensional cross-sectional view of the first elastic structure 31 shown in FIG. 9.

The first elastic structure 31 includes a base 311, a first pressing member 312, and a first elastic member 313.

The base 311 is disposed on the first limiting portion 11, and the base 311 is provided with a sliding hole 3111. One end of the sliding hole 3111 is closed to form a closed end 3111b, and the other end of the sliding hole 3111 is opened to form an open end 3111a. The open end 3111a is located on a side that is of the closed end 3111b and that faces the first concave-convex surface region 33.

The first pressing member 312 is disposed in the sliding hole 3111 and is capable of sliding along the sliding hole 3111, and a part of the first pressing member 312 projects from the open end 3111a.

The first elastic member 313 is disposed in the sliding hole 3111 and is located between the closed end 3111b and the first pressing member 312.

The part that is of the first pressing member 312 and that projects from the open end 3111a fits with the first concave-convex surface region 33.

In this structure, an elastic force is provided by using the first elastic member 313, the first pressing member 312 is used for contact and friction with the first concave-convex surface region 33, the first elastic member 313 may be produced by using a structure with a stable elastic force, and the first pressing member 312 may be produced by using a material with relatively good wear resistance performance. The arrangement is suitable, and can prolong a service life of the first elastic structure 31. In addition, both the first pressing member 312 and the first elastic member 313 are fastened to the base 311. In this way, the first elastic structure 31 can be used as an independent product and assembled with the first limiting portion 11, so that assembly efficiency of the sliding mechanism 233 can be improved.

The first pressing member 312 includes but is not limited to a ball plunger, an ejector pin, or a pressing block. In the embodiments shown in FIG. 9 and FIG. 10, the first pressing member 312 is a ball plunger. In this way, a surface that is of the first pressing member 312 and that is in contact with the first concave-convex surface region 33 is a convex spherical surface, so that smooth sliding can be ensured, and getting stuck can be avoided. In addition, in some embodiments, primarily referring to FIG. 10, the ball plunger is in contact with the first elastic member 313 but is unfixed. In this way, in a process in which the sliding member 2 slides relative to the sliding rail 1, the first pressing member 312 can roll along the first concave-convex surface region 33, so that flexibility is relatively good, and a possibility of getting stuck is further reduced.

In addition, the first elastic member 313 includes but is not limited to a cylindrical helical spring, a torsion spring, a tower spring, a rubber strip, an elastic compressible material, or the like. In the embodiment shown in FIG. 10, the first elastic member 313 is a cylindrical helical spring. The cylindrical helical spring is simple in structure, can provide a relatively large elastic force, and has a relatively long service life. Therefore, structural strength of the first elastic structure 31 can be ensured, and the service life of the first elastic structure 31 can be prolonged.

In addition, the base 311 may be welded, be in interference fit with, or be bonded to the first limiting portion 11. This is not specifically limited herein.

In some embodiments, referring to FIG. 11, FIG. 11 is a partial cross-sectional view, at the first elastic structure 31, of the sliding mechanism 233 shown in FIG. 6. The first limiting portion 11 is provided with a first threaded hole 11a, and an end of the first threaded hole 11a penetrates the first inner surface S1. A first external thread 3112 is disposed on an outer circumference of the base 311, and an axial direction of the first external thread 3112 is parallel to an axial direction of the sliding hole 3111. The base 311 is accommodated in the first threaded hole 11a, and the first external thread 3112 is in threaded fit with the first threaded hole 11a. In this way, the base 311 is rotated in the first threaded hole 11a, to adjust a position of the first elastic structure 31 in the axial direction of the first threaded hole 11a, so that an elastic force of the first elastic structure 31 is adjusted. In addition, after the first pressing member 312 is worn, the service life of the first elastic structure 31 can be prolonged by adjusting the position of the first elastic structure 31.

To facilitate an assembly operation of the first pressing member 312 and the first elastic member 313 in the sliding hole 3111, in some embodiments, referring back to FIG. 10, the base 311 includes a base body 311a and a fastening member 311b. The first external thread 3112 and the sliding hole 3111 are disposed on the base body 311a. The base body 311a is further provided with an inner hole 3113. The inner hole 3113 is located on a side that is of the closed end 3111b and that is away from the open end 3111a, the inner hole 3113 and the sliding hole 3111 are coaxially disposed and communicate with each other, and an end that is of the inner hole 3113 and that is away from the sliding hole 3111 penetrates the base body 311a. The fastening member 311b is disposed in the inner hole 3113. In this way, the first pressing member 312 and the first elastic member 313 can be installed in the sliding hole 3111 from the inner hole 3113, and then the fastening member 311b is assembled in the inner hole 3113. Therefore, assembly of the first pressing member 312 and the first elastic member 313 is implemented. This assembly manner is simple and easy to operate. In another embodiment, the first pressing member 312 and the first elastic member 313 may alternatively be assembled into the sliding hole 3111 from the open end 3111a. This is not specifically limited herein.

In some embodiments, referring to FIG. 10, a part that is of the sliding hole 3111 and that forms the open end 3111a is tapered in a direction from the closed end 3111b to the open end 3111a. In this way, the first pressing member 312 can be prevented, by using the tapered part, from being detached from the open end 3111a.

In the foregoing embodiment, a manner of fastening the fastening member 311b in the inner hole 3113 includes but is not limited to a threaded connection, welding, or interference fit. In some embodiments, still referring to FIG. 10, the inner hole 3113 is a second threaded hole, a second external thread 311b1 is disposed on an outer circumference of the fastening member 311b, and the second external thread 311b1 is in threaded fit with the second threaded hole. In this way, the inner hole 3113 is threadedly connected to the inner hole 3113. This connection manner is simple and can implement disassembly. After the first pressing member 312 is worn, the first pressing member 312 can be easily replaced, so that maintenance costs of the first elastic structure 31 can be reduced.

For ease of assembly and position adjustment operations of the first elastic structure 31 in the first limiting portion 11, in some embodiments, referring to FIG. 11, the first limiting portion 11 further includes a first outer surface S7, the first outer surface S7 and the first inner surface S1 face away from each other, and the first threaded hole 11a penetrates the first outer surface S7. Referring to FIG. 10 and FIG. 11 together, an end surface that is of the fastening member 311b and that is away from the sliding hole 3111 is provided with an operating slot 311b2. The operating slot 311b2 is a non-circular slot, in other words, the operating slot 311b2 is not a circular slot. Specifically, the operating slot 311b2 may be an elliptical slot, a triangular slot, a square slot, a pentagonal slot, a hexagonal slot, a heart-shaped slot, or the like. This is not specifically limited herein. FIG. 10 and FIG. 11 provide descriptions by using an example in which the operating slot 311b2 is a hexagonal slot.

In this way, an assembly person holds an operating tool and enables the operating tool to engage with the operating slot 311b2, to drive the first elastic structure 31 to rotate, so that the first elastic structure 31 is installed in the first threaded hole 11a through an opening at an end that is of the first threaded hole 11a and that penetrates the first outer surface S7. In addition, an adjustment to the position of the first elastic structure 31 in the first threaded hole 11a can be further implemented by using the operating tool, so that the elastic force of the first elastic structure 31 is adjusted. The installation and adjustment operations are easy.

On the basis of the foregoing embodiment, optionally, rotation directions of the first external thread 3112 and the second external thread 311b1 may be opposite to each other. For example, the first external thread 3112 is one of a left-hand thread and a right-hand thread, and the second external thread 311b1 is the other one of the left-hand thread and the right-hand thread. In this way, when the first elastic structure 31 is installed or adjusted by using the operating tool, detachment of the fastening member 311b from the base body 311a can be avoided, so that structural stability of the first elastic structure 31 can be ensured.

In another embodiment, rotation directions of the first external thread 3112 and the second external thread 311b1 may alternatively be the same. On the basis of this, fitting tightness between the second external thread 311b1 and the second threaded hole is greater than fitting tightness between the first external thread 3112 and the first threaded hole 11a. In this way, when the first elastic structure 31 is installed or adjusted by using the operating tool, detachment of the fastening member 311b from the base body 311a can also be avoided.

In another embodiment, the first threaded hole 11a may alternatively not penetrate the first outer surface S7. On the basis of this, the first elastic structure 31 may be installed or adjusted from the opening at the end that is of the first threaded hole 11a and that penetrates the first inner surface S1. This is not specifically limited herein.

The foregoing describes the structure of the first elastic structure 31. Certainly, the structure of the first elastic structure 31 is not limited thereto. In another embodiment, the first elastic structure 31 may alternatively not include the base 311. In some other embodiments, the entire first elastic structure 31 may be made of an elastic material. This is not specifically limited herein.

Structures of the second elastic structure 32 and the first elastic structure 31 may be the same or different. This embodiment and the following embodiments provide descriptions by using an example in which the structures of the second elastic structure 32 and the first elastic structure 31 are the same.

Referring back to FIG. 8, the first elastic structure 31 and the second elastic structure 32 each apply a specific elastic force to the first side surface S4. The elastic force is perpendicular to the first side surface S4 or has a component force perpendicular to the first side surface S4, and the force perpendicular to the first side surface S4 is positive pressure F_{N}. When the sliding member 2 slides in the Y-axis direction relative to the sliding rail 1, friction is generated under an action of the positive pressure F_{N}, and an friction force F_{firiction}=µF_{N}. µ is a dynamic friction coefficient, and is positively correlated with roughness of the first side surface S4. Therefore, the sliding mechanism 233 has a damping function.

On the basis of the above, the first concave-convex surface region 33 and the second concave-convex surface region 34 are uneven regions.

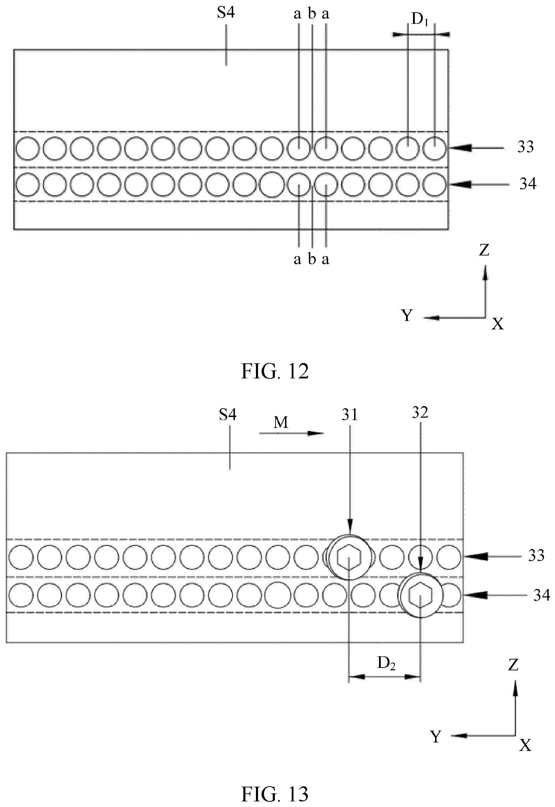

Specifically, referring to FIG. 12, FIG. 12 is a schematic diagram of a structure, at the first side surface S4, of the sliding member 2 in the sliding mechanism 233 shown in FIG. 8. The first concave-convex surface region 33 and the second concave-convex surface region 34 each include a plurality of concave surface portions a spaced apart in the Y-axis direction. The concave surface portion a includes but is not limited to a concave spherical surface, a concave arc surface, an inverted cone-shaped surface, an inverted cone frustum surface whose side surface is an inclined surface and whose bottom surface is a flat surface, or the like. In this embodiment, the concave surface portion a is a concave spherical surface.

A convex surface portion b is formed between two adjacent concave surface portions a. The convex surface portion b is a surface that protrudes at a higher position than the concave surface portion a. The convex surface portion b may be in a planar shape, or may be in a shape of a convex surface. This embodiment provides descriptions by using an example in which the convex surface portion b is in a planar shape. This cannot be considered to constitute a special limitation on this application.

On the basis of the above, in the process in which the sliding member 2 slides relative to the sliding rail 1, when the first elastic structure 31 fits with the concave surface portion a of the first concave-convex surface region 33, the second elastic structure 32 fits with a convex surface portion b of the second concave-convex surface region 34, and when the first elastic structure 31 fits with a convex surface portion b of the first concave-convex surface region 33, the second elastic structure 32 fits with the concave surface portion a of the second concave-convex surface region 34.

It should be noted that "the first elastic structure 31 fits with the concave surface portion a of the first concave-convex surface region 33" means that the first elastic structure 31 is located on a side that the concave surface portion a of the first concave-convex surface region 33 faces and the first elastic structure 31 elastically abuts or is in contact with the concave surface portion a or there is a specific gap between the first elastic structure 31 and the concave surface portion a. "Elastic abutting" indicates that the first elastic structure 31 and the concave surface portion a come into contact with each other by using an elastic force, and the elastic force comes from the first elastic structure 31. Similar expressions in the following descriptions should be understood in a same way, and details are not described below. "Contact" means that the first elastic structure 31 and the concave surface portion a are in contact with each other without a mutual squeezing force.

"The second elastic structure 32 fits with the convex surface portion b of the second concave-convex surface region 34" means that the second elastic structure 32 is located on a side that the convex surface portion b of the second concave-convex surface region 34 faces and the second elastic structure 32 elastically abuts the convex surface portion b.

"The first elastic structure 31 fits with the convex surface portion b of the first concave-convex surface region 33" means that the first elastic structure 31 is located on a side that the convex surface portion b of the first concave-convex surface region 33 faces, and the first elastic structure 31 elastically abuts the convex surface portion b.

"The second elastic structure 32 fits with the concave surface portion a of the second concave-convex surface region 34" means that the second elastic structure 32 is located on a side that the concave surface portion a of the second concave-convex surface region 34 faces and the second elastic structure 32 elastically abuts or is in contact with the concave surface portion a or there is a specific gap between the second elastic structure 32 and the concave surface portion a.

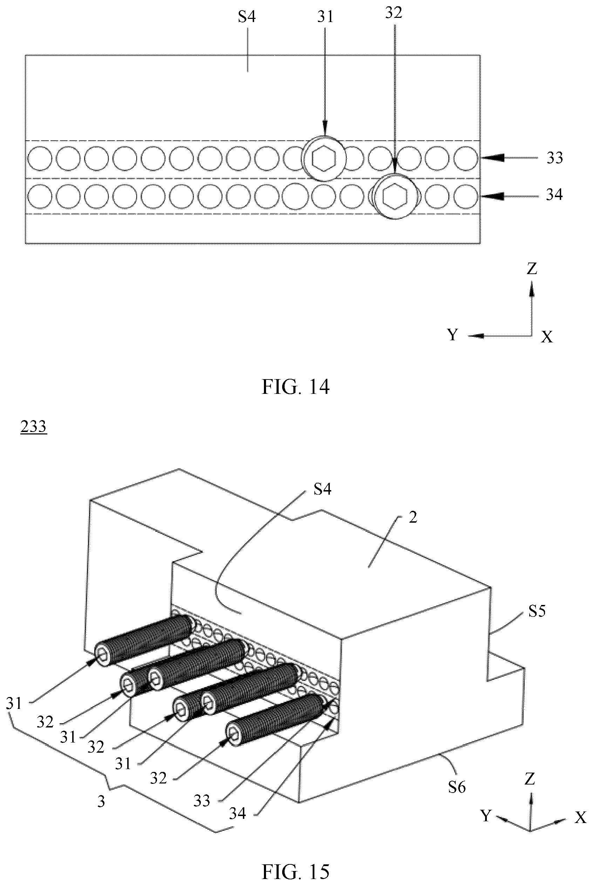

Referring to FIG. 13, FIG. 13 is a schematic diagram of a relative position between the structure shown in FIG. 12 and the first elastic structure 31 and a relative structure between the structure shown in FIG. 12 and the second elastic structure 32. At a moment shown in FIG. 13, the first elastic structure 31 fits with the convex surface portion b of the first concave-convex surface region 33, and the second elastic structure 32 fits with the concave surface portion a of the second concave-convex surface region 34. Referring to FIG. 14, FIG. 14 is a schematic diagram of a structure existing after a sliding member 2 in the structure shown in FIG. 13 moves by a specific distance in a direction M relative to the first elastic structure 31 and the second elastic structure 32. At a moment shown in FIG. 14, the first elastic structure 31 fits with the concave surface portion a of the first concave-convex surface region 33, and the second elastic structure 32 fits with the convex surface portion b of the second concave-convex surface region 34.

In this way, when the sliding member 2 slides relative to the sliding rail 1, the first elastic structure 31 slides along the first concave-convex surface region 33, and the second elastic structure 32 slides along the second concave-convex surface region 34. In addition, when the first elastic structure 31 fits with the concave surface portion a, the second elastic structure 32 fits with the convex surface portion b, and when the first elastic structure 31 fits with the convex surface portion b, the second elastic structure 32 fits with the concave surface portion a. On the basis of this, when the first elastic structure 31 and the second elastic structure 32 fit with the concave surface portions a, an elastic force exerted on the first side surface S4 is relatively small, and a friction force F_{friction} is relatively small, and may even be zero; and when the first elastic structure 31 and the second elastic structure 32 fit with the convex surface portions b, the elastic force exerted on the first side surface S4 is relatively large, and the friction force F_{friction} is relatively large. Therefore, the alternate fitting can improve continuity and stability of the friction force F_{friction}. When the sliding mechanism 233 is applied to the movable connection apparatus in the electronic device, there is no need to additionally dispose a damping mechanism. Therefore, occupied space of the movable connection apparatus can be reduced, which is conducive to thinning or miniaturization of the electronic device.

In some embodiments, referring back to FIG. 12, a distance between two adjacent concave surface portions a of the first concave-convex surface region 33 is equal to a distance between two adjacent concave surface portions a of the second concave-convex surface region 34, and both the distances are a first distance D₁. "The distance between two adjacent concave surface portions a" is a distance between geometric centers of the two adjacent concave surface portions a.

Still referring to FIG. 12, the first concave-convex surface region 33 and the second concave-convex surface region 34 are arranged in alignment with each other in the Y-axis direction, to be specific, the plurality of concave surface portions a of the first concave-convex surface region 33 and the plurality of concave surface portions a of the second concave-convex surface region 34 are respectively arranged in alignment with each other in the Y-axis direction.

The first concave-convex surface region 33 and the second concave-convex surface region 34 are different concave-convex surface regions. Specifically, the first concave-convex surface region 33 and the second concave-convex surface region 34 are spaced apart in a second direction, the second direction is perpendicular to the first direction, the second direction is parallel to the first side surface S4, and the second direction is the Z-axis direction. In this way, when the sliding member 2 slides relative to the sliding rail 1, friction forces are staggered along Z-axis direction, so that uniform distribution and stability of the friction forces can be ensured. In addition, the first elastic structure 31 and the second elastic structure 32 are respectively in contact and friction with different concave-convex surface regions, so that wear can be reduced.

Referring to FIG. 13, the first elastic structure 31 and the second elastic structure 32 are also spaced apart in the Z-axis direction. In addition, a distance between the first elastic structure 31 and the second elastic structure 32 in the Y-axis direction is a second distance D₂, and the second distance D₂ meets a condition: D₂=(K+1/2)×D₁.

K is 0 or a positive integer greater than 0. In the embodiment shown in FIG. 13, K=2.

In addition, it should be noted that in this embodiment and the following embodiments, "D₂=(K+1/2)×D₁" is not limited to absolute equality between D₂ and (K+1/2)×D₁, and when an absolute value of a difference between D₂ and (K+1/2)×D₁ is less than or equal to D₁/8, it may be considered that the second distance D₂ meets the condition: D₂=(K+1/2)×D₁.

In this arrangement manner, in the process in which the sliding member 2 slides relative to the sliding rail 1, when the first elastic structure 31 fits with the concave surface portion a of the first concave-convex surface region 33, the second elastic structure 32 fits with the convex surface portion b of the second concave-convex surface region 34, and when the first elastic structure 31 fits with the convex surface portion b of the first concave-convex surface region 33, the second elastic structure 32 fits with the concave surface portion a of the second concave-convex surface region 34. This arrangement manner is simple and easy to operate.

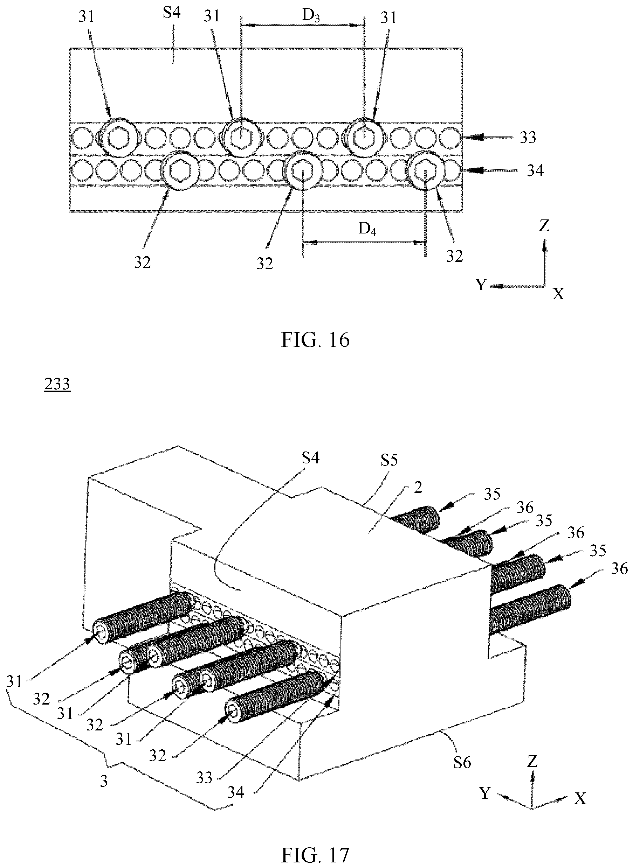

On the basis of the above, optionally, referring to FIG. 15 and FIG. 16, FIG. 15 is a three-dimensional view existing after the sliding rail 1 is hidden from the sliding mechanism 233 according to some other embodiments of this application, and FIG. 16 is a schematic diagram of a structure, at the first side surface S4, of the structure shown in FIG. 15. There are a plurality of, for example, three, first elastic structures 31. The plurality of first elastic structures 31 are successively arranged in the Y-axis direction, and all of the plurality of first elastic structures 31 fit with the concave surface portions a of the first concave-convex surface region 33, or all of the plurality of first elastic structures 31 fit with convex surface portions b of the first concave-convex surface region 33. Correspondingly, there are also a plurality of, for example, three, second elastic structures 32. The plurality of second elastic structures 32 are successively arranged in the Y-axis direction, and all of the plurality of second elastic structures 32 fit with convex surface portions b of the second concave-convex surface region 34, or all of the plurality of second elastic structures 32 fit with the concave surface portions a of the second concave-convex surface region 34.

In the process in which the sliding member 2 slides relative to the sliding rail 1, when the plurality of first elastic structures 31 fit with the concave surface portions a of the first concave-convex surface region 33, the plurality of second elastic structures 32 fit with the convex surface portions b of the second concave-convex surface region 34, and when the plurality of first elastic structures 31 fit with the convex surface portions b of the first concave-convex surface region 33, the plurality of second elastic structures 32 fit with the concave surface portions a of the second concave-convex surface region 34.

In this way, the plurality of first elastic structures 31 and second elastic structure 32 are disposed, so that a combined elastic force applied to the first side surface S4 can be increased, thereby increasing a total friction force and improving a damping function of the damping assembly 3.

In the foregoing embodiment, to ensure that all of the plurality of first elastic structures 31 fit with the concave surface portions a of the first concave-convex surface region 33, or all of the plurality of first elastic structures 31 fit with the convex surface portion b of the first concave-convex surface region 33, optionally, a distance between two adjacent first elastic structures 31 is a third distance D₃, and the third distance D₃ meets a condition: D₃=E×D₁. Correspondingly, to ensure that all of the plurality of second elastic structures 32 fit with the convex surface portions b of the second concave-convex surface region 34, or all of the plurality of second elastic structures 32 fit with the concave surface portions a of the second concave-convex surface region 34, optionally, a distance between two adjacent second elastic structures is a fourth distance D₄, and the fourth distance D₄ meets a condition: D₄=F×D₁. E and F are positive integers greater than 0. E and F may be equal or unequal. This embodiment provides descriptions by using an example in which E and F are equal and both E and F are equal to 5. In addition, it should be noted that "D₃=E×D₁" is not limited to absolute equality between D₃ and E×D₁, and when an absolute value of a difference between D₃ and E×D₁ is less than or equal to D₁/8, it may be considered that the third distance D₃ meets the condition: D₃=E×D₁. Similarly, "D₄=F×D₁" is not limited to absolute equality between D₄ and F×D₁, and when an absolute value of a difference between D₄ and F×D₁ is less than or equal to D₁/8, it may be considered that the fourth distance D₄ meets the condition: D₄=F×D₁.

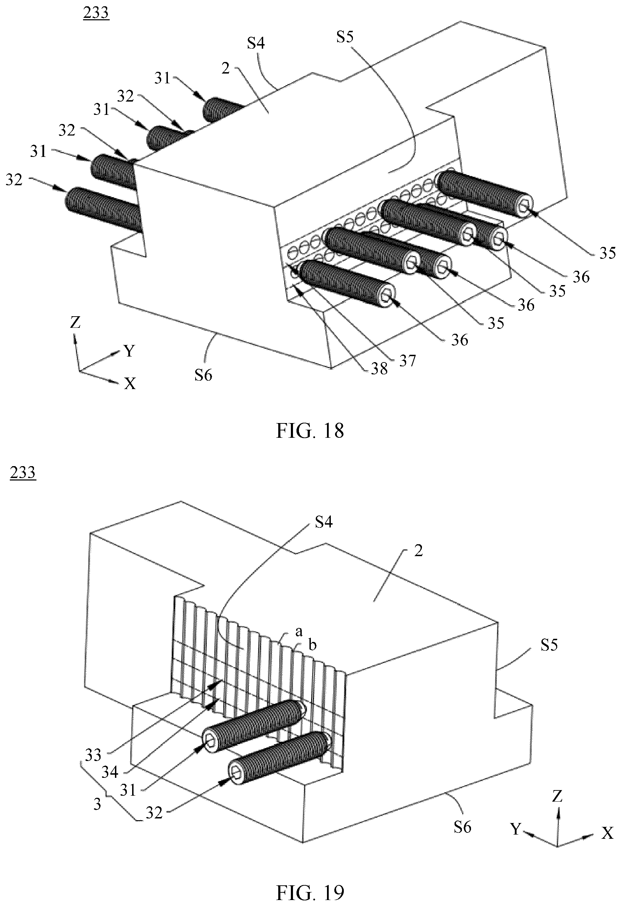

To further improve the damping function of the damping assembly 3, in some embodiments, referring to FIG. 17 and FIG. 18, FIG. 17 is a three-dimensional view existing after the sliding rail 1 is hidden from the sliding mechanism 233 according to some other embodiments of this application, and FIG. 18 is a three-dimensional view of the sliding mechanism 233 shown in FIG. 17 from another perspective. In this embodiment, in addition to the first elastic structure 31, the second elastic structure 32, the first concave-convex surface region 33, and the second concave-convex surface region 34, the damping assembly 3 includes a third elastic structure 35, a fourth elastic structure 36, a third concave-convex surface region 37, and a fourth concave-convex surface region 38. The third elastic structure 35 and the fourth elastic structure 36 are disposed on the second limiting portion 12 (not shown in the figure), the third elastic structure 35 and the first elastic structure 31 are symmetrical to each other, and the fourth elastic structure 36 and the second elastic structure 32 are symmetrical to each other. The third concave-convex surface region 37 and the fourth concave-convex surface region 38 are disposed on the second side surface S5, the third concave-convex surface region 37 and the first concave-convex surface region 33 are symmetrical to each other, and the fourth concave-convex surface region 38 and the second concave-convex surface region 34 are symmetrical to each other. In addition, the third elastic structure 35 fits with the third concave-convex surface region 37, and the fourth elastic structure 36 fits with the fourth concave-convex surface region 38.

In this way, in the damping assembly 3, in addition to generating a friction force through fitting between the first elastic structure 31 and the first concave-convex surface region 33 and fitting between the second elastic structure 32 and the second concave-convex surface region 34, a friction force is generated through fitting between the third elastic structure 35 and the third concave-convex surface region 37 and fitting between the fourth elastic structure 36 and the fourth concave-convex surface region 38, so that the damping function of the damping assembly 3 can be further improved. In addition, two opposite sides of the sliding member 2 are subjected to friction forces at the same time. In the process of sliding relative to the sliding rail 1, the sliding member 2 has relatively good stability, to prevent the sliding member 2 from being tilted or even stuck.

The foregoing embodiments provide descriptions by using an example in which the first concave-convex surface region 33 and the second concave-convex surface region 34 are arranged in alignment with each other in the Y-axis direction and the first concave-convex surface region 33 and the second concave-convex surface region 34 are spaced apart in the Z-axis direction. On the basis of this, optionally, referring to FIG. 19, FIG. 19 is a three-dimensional view existing after the sliding rail 1 is hidden from the sliding mechanism 233 according to some other embodiments of this application. The plurality of concave surface portions a of the first concave-convex surface region 33 are respectively aligned with and connected to the plurality of concave surface portions a of the second concave-convex surface region 34 to form an integral concave surface portion, and the plurality of convex surface portions b of the first concave-convex surface region 33 are respectively aligned with and connected to the plurality of convex surface portions b of the second concave-convex surface region 34 to form an integral convex surface portion. In this way, surfaces on which the first concave-convex surface region 33 and the second concave-convex surface region 34 are located are simple in profile and are easy to machine.

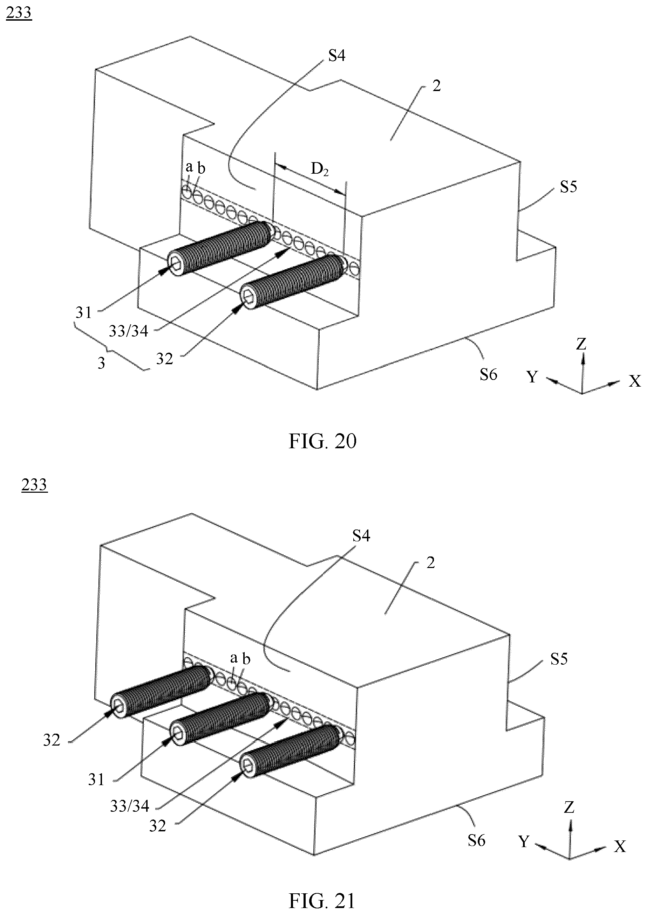

In some other embodiments, when the first concave-convex surface region 33 and the second concave-convex surface region 34 are arranged in alignment with each other in the Y-axis direction, the first concave-convex surface region 33 and the second concave-convex surface region 34 may alternatively be a same concave-convex surface region. For example, referring to FIG. 20, FIG. 20 is a three-dimensional view existing after the sliding rail 1 is hidden from the sliding mechanism 233 according to some other embodiments of this application. The first concave-convex surface region 33 and the second concave-convex surface region 34 are a same concave-convex surface region. On the basis of this, the first elastic structure 31 and the second elastic structure 32 are arranged in a row in the Y-axis direction, and the second distance D₂ meets the condition: D₂=(K+1/2)×D₁.

In this way, the first elastic structure 31 and the second elastic structure 32 are arranged in alignment with each other in the Z-axis direction. When the sliding member 2 slides relative to the sliding rail 1, the first elastic structure 31 and the second elastic structure 32 slide along a same concave-convex surface region. In addition, when the first elastic structure 31 fits with the concave surface portion a, the second elastic structure 32 fits with the convex surface portion b, and when the first elastic structure 31 fits with the convex surface portion b, the second elastic structure 32 fits with the concave surface portion a. At a moment shown in FIG. 20, the first elastic structure 31 fits with the convex surface portion b, and the second elastic structure 32 fits with the concave surface portion a. Therefore, the alternate fitting can also improve continuity and stability of the friction force F_{friction}. In addition, the first elastic structure and the second elastic structure fit with the same concave-convex surface region. This structure is simple, and machining costs are relatively low.

On the basis of the above, to improve the damping function of the damping assembly 3, in some embodiments, referring to FIG. 21, FIG. 21 is a three-dimensional view existing after the sliding rail 1 is hidden from the sliding mechanism 233 according to some other embodiments of this application. There is at least one first elastic structure 31, and there is also at least one second elastic structure 32. For example, in FIG. 21, there is one first elastic structure 31 and two second elastic structures 32. The at least one first elastic structure 31 and the at least one second elastic structure 32 are successively alternately arranged in the Y-axis direction. In this way, a quantity of first elastic structures 31 and a quantity of second elastic structures 32 can be increased, to increase a combined elastic force applied to the first side surface S4, so that a total friction force can be increased, and the damping function of the damping assembly 3 can be improved.

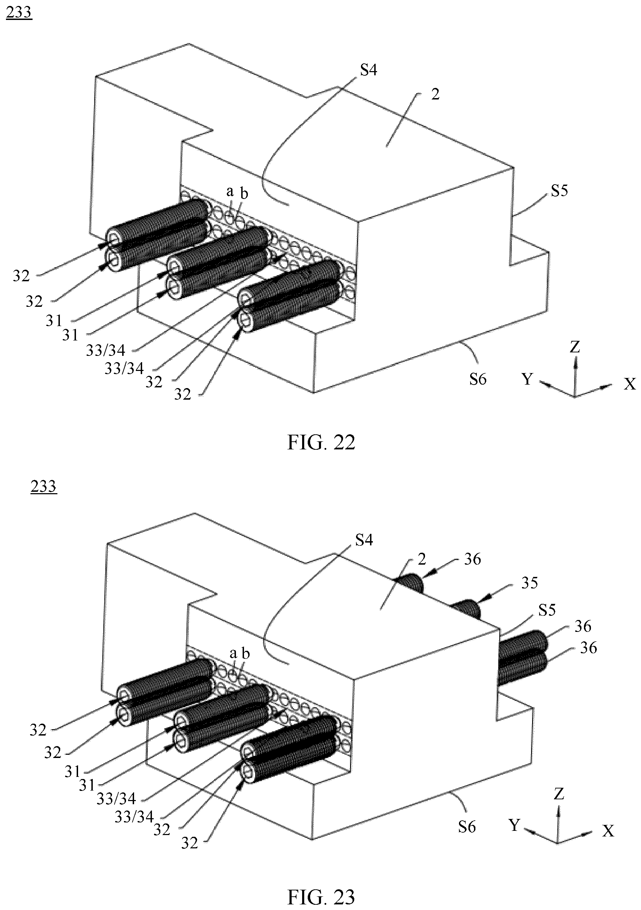

To further improve the damping function of the damping assembly 3, in some embodiments, referring to FIG. 22, FIG. 22 is a three-dimensional view existing after the sliding rail 1 is hidden from the sliding mechanism 233 according to some other embodiments of this application. First elastic structures 31 and second elastic structures 32 are arranged into a plurality of rows of elastic structures, and each row of elastic structures is formed by successively alternately arranging at least one first elastic structure 31 and at least one second elastic structure 32. In this way, the specified quantity of first elastic structures 31 and the specified quantity of second elastic structures 32 can be further increased, so that the combined elastic force applied to the first side surface S4 can be further increased, thereby increasing the total friction force and improving the damping function of the damping assembly 3.

To further improve the damping function of the damping assembly 3, in some embodiments, referring to FIG. 23, FIG. 23 is a three-dimensional view existing after the sliding rail 1 is hidden from the sliding mechanism 233 according to some other embodiments of this application. In this embodiment, in addition to the first elastic structure 31, the second elastic structure 32, the first concave-convex surface region 33, and the second concave-convex surface region 34, the damping assembly 3 includes a third elastic structure 35, a fourth elastic structure 36, a third concave-convex surface region, and a fourth concave-convex surface region. The third elastic structure 35 and the fourth elastic structure 36 are disposed on the second limiting portion 12 (not shown in the figure), the third elastic structure 35 and the first elastic structure 31 are symmetrical to each other, and the fourth elastic structure 36 and the second elastic structure 32 are symmetrical to each other. The third concave-convex surface region and the fourth concave-convex surface region are disposed on the second side surface S5, the third concave-convex surface region and the fourth concave-convex surface region are a same concave-convex surface region, the third elastic structure 35 and the fourth elastic structure 36 fit with the same concave-convex surface region, and the same concave-convex surface region is symmetrical to a same concave-convex surface region formed by the first concave-convex surface region 33 and the second concave-convex surface region 34.

In this way, in the damping assembly 3, in addition to generating a friction force through fitting of the first elastic structure 31 and the second elastic structure 32 with the same concave-convex surface region formed by the first concave-convex surface region 33 and the second concave-convex surface region 34, a friction force is generated through fitting of the third elastic structure 35 and the fourth elastic structure 36 with the same concave-convex surface region formed by the third concave-convex surface region and the fourth concave-convex surface region, so that the damping function of the damping assembly 3 can be further improved. In addition, two opposite sides of the sliding member 2 are subjected to friction forces at the same time. In the process of sliding relative to the sliding rail 1, the sliding member 2 has relatively good stability, to prevent the sliding member 2 from being tilted or even stuck.

The foregoing embodiments provide descriptions by using an example in which the first elastic structure 31 and the second elastic structure 32 are disposed on the first limiting portion 11 and the first concave-convex surface region 33 and the second concave-convex surface region 34 are disposed on the first side surface S4. In some other embodiments, the first elastic structure 31 and the second elastic structure 32 may alternatively be disposed on the sliding member 2, and the first concave-convex surface region 33 and the second concave-convex surface region 34 may be disposed on the sliding rail. Specifically, the first elastic structure 31 and the second elastic structure 32 may be disposed on at least a part of the sliding member 2 in the sliding groove C, and the first concave-convex surface region 33 and the second concave-convex surface region 34 may be disposed on the first inner surface S1. In some other embodiments, alternatively, the first elastic structure 31 may be disposed on the first limiting portion 11, and the first concave-convex surface region 33 may be disposed on the first side surface S4, whereas the second elastic structure 32 is disposed on the second limiting portion 12, and the second concave-convex surface region 34 is disposed on the second side surface S5. Alternatively, the first elastic structure 31 and the second elastic structure 32 are disposed on at least a part of the sliding member 2 in the sliding groove C, the first concave-convex surface region 33 is disposed on the first inner surface S1, and the second concave-convex surface region 34 is disposed on the second inner surface S2. In some other embodiments, alternatively, the first elastic structure 31 may be disposed on the first limiting portion 11, and the first concave-convex surface region 33 is disposed on the first side surface S4, whereas the second elastic structure 32 is disposed on the connecting member 234, and the second concave-convex surface region 34 is disposed on the third side surface S6. Alternatively, the first elastic structure 31 and the second elastic structure 32 are disposed on at least a part of the sliding member 2 in the sliding groove C, the first concave-convex surface region 33 is disposed on the first inner surface S1, and the second concave-convex surface region 34 is disposed on the third inner surface S3. It only needs to be ensured that one of the first elastic structure 31 and the first concave-convex surface region 33 is disposed on the sliding rail 1 and the other thereof is disposed on the sliding member 2, and one of the second elastic structure 32 and the second concave-convex surface region 34 is disposed on the sliding rail 1 and the other thereof is disposed on the sliding member 2. No exhaustive enumeration is provided herein.

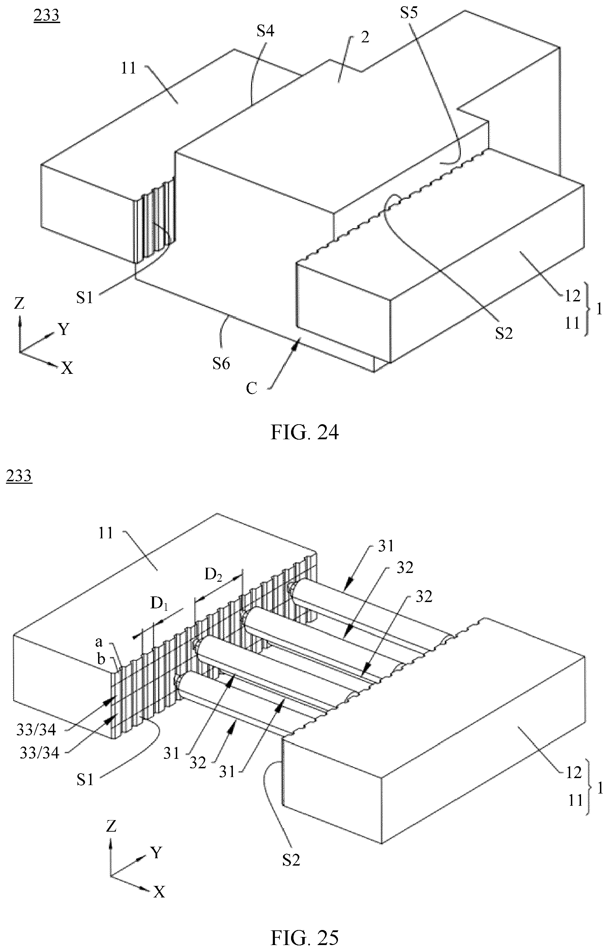

For example, referring to FIG. 24 and FIG. 25, FIG. 24 is a three-dimensional view of the sliding mechanism 233 according to some other embodiments of this application, and FIG. 25 is a three-dimensional view existing after the sliding member 2 is hidden from the sliding mechanism 233 shown in FIG. 24. In this embodiment, the first elastic structure 31 and the second elastic structure 32 are disposed on at least a part of the sliding member 2 in the sliding groove C, and the first concave-convex surface region 33 and the second concave-convex surface region 34 are disposed on the first inner surface S1. This structure is simple and easy to implement.

In the embodiment shown in FIG. 25, the first concave-convex surface region 33 and the second concave-convex surface region 34 are a same concave-convex surface region. On the basis of this, the first elastic structure 31 and the second elastic structure 32 are spaced apart in the Y-axis direction, and the second distance D₂ meets the condition: D₂=(K+1/2)×D₁.

In this way, the first elastic structure 31 and the second elastic structure 32 are arranged in alignment with each other in the Z-axis direction. When the sliding member 2 slides relative to the sliding rail 1, the first elastic structure 31 and the second elastic structure 32 slide along a same concave-convex surface region. In addition, when the first elastic structure 31 fits with the concave surface portion a, the second elastic structure 32 fits with the convex surface portion b, and when the first elastic structure 31 fits with the convex surface portion b, the second elastic structure 32 fits with the concave surface portion a. At a moment shown in FIG. 25, the first elastic structure 31 fits with the convex surface portion b, and the second elastic structure 32 fits with the concave surface portion a. Therefore, the alternate fitting can also improve continuity and stability of the friction force F_{friction}.

In the embodiment shown in FIG. 25, first elastic structures 31 and second elastic structures 32 are arranged into a plurality of rows of elastic structures, and each row of elastic structures is formed by successively alternately arranging at least one first elastic structure 31 and at least one second elastic structure 32. In this way, the specified quantity of first elastic structures 31 and the specified quantity of second elastic structures 32 can be further increased, so that the combined elastic force applied to the first side surface S4 can be further increased, thereby increasing the total friction force and improving the damping function of the damping assembly 3.

On the basis of the foregoing embodiment, in the concave-convex surface region separately fitting with the plurality of rows of elastic structures, concave surface portions a are aligned with and connected to each other to form an integral concave surface portion, and convex surface portions b are aligned with and connected to each other to form an integral convex surface portion. In this way, the first inner surface S1 is in a shape of a serrated surface, and the first inner surface S1 is simple in profile and easy to machine.

In the embodiment shown in FIG. 25, a structure of the first elastic structure 31 is also different from the structure of the foregoing first elastic structure 31.

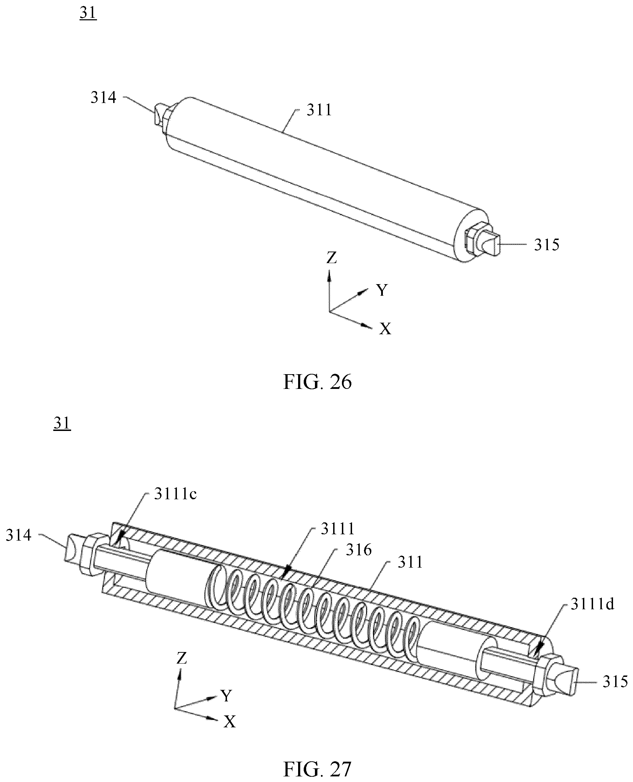

Specifically, referring to FIG. 26 and FIG. 27, FIG. 26 is a three-dimensional view of the first elastic structure 31 in the sliding mechanism 233 shown in FIG. 25, and FIG. 27 is a three-dimensional cross-sectional view of the first elastic structure 31 shown in FIG. 26. The first elastic structure 31 includes a base 311, a second pressing member 314, a third pressing member 315, and a second elastic member 316.

The base 311 is disposed on the at least a part of the sliding member 2 in the sliding groove C. The base 311 is provided with a sliding hole 3111, one end of the sliding hole 3111 is opened to form a first open end 3111c, and the other end of the sliding hole 3111 is opened to form a second open end 3111d. The first open end 3111c faces the first inner surface S1, and the second open end 3111d faces the second inner surface S2.

The second pressing member 314 is disposed in the sliding hole 3111 and is capable of sliding along the sliding hole 3111, and a part of the second pressing member 314 projects from the first open end 3111c.

The third pressing member 315 is disposed in the sliding hole 3111 and is capable of sliding along the sliding hole 3111, and a part of the third pressing member 315 projects from the second open end 3111d.

The second elastic member 316 is disposed in the sliding hole 3111 and is located between the second pressing member 314 and the third pressing member 315. Referring to FIG. 25, the second pressing member 314 fits with the first concave-convex surface region 33, and the third pressing member 315 fits with the second inner surface S2.

In this structure, an elastic force is provided by using the second elastic member 316, the second pressing member 314 is used for contact and friction with the first concave-convex surface region 33, the third pressing member 315 is used for contact and friction with the second inner surface S2, the second elastic member 316 may be produced by using a structure with a stable elastic force, and the second pressing member 314 and the third pressing member 315 may be produced by using a material with relatively good wear resistance performance. The arrangement is suitable, and can prolong a service life of the first elastic structure 31. In addition, all of the second pressing member 314, the third pressing member 315, and the second elastic member 316 are fastened to the base 311. In this way, the first elastic structure 31 can be used as an independent product and assembled with the sliding member 2, so that assembly efficiency of the sliding mechanism 233 can be improved.

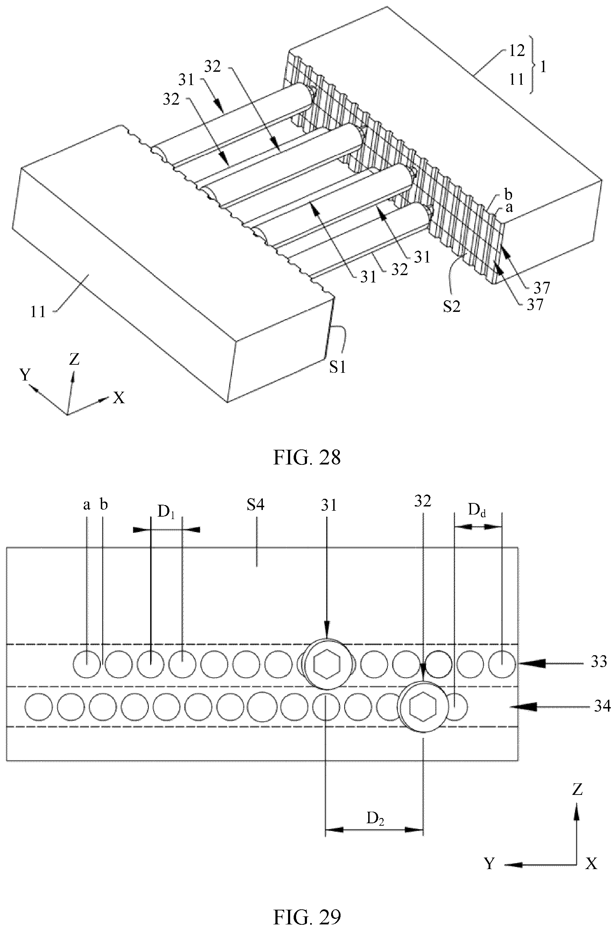

In the foregoing embodiment, the second pressing member 314 and the third pressing member 315 each include but are not limited to a ball plunger, an ejector pin, or a pressing block. In the embodiments shown in FIG. 27 and FIG. 28, the second pressing member 314 and the third pressing member 315 are ejector pins.

In addition, the second elastic member 316 includes but is not limited to a cylindrical helical spring, a torsion spring, a tower spring, a rubber strip, an elastic compressible material, or the like. In the embodiment shown in FIG. 28, the second elastic member 316 is a cylindrical helical spring. The cylindrical helical spring is simple in structure, can provide a relatively large elastic force, and has a relatively long service life. Therefore, structural strength of the first elastic structure 31 can be ensured, and the service life of the first elastic structure 31 can be prolonged.

In addition, the base 311 may be welded, be in interference fit with, or be bonded to the sliding member 2. This is not specifically limited herein.

On the basis of the foregoing embodiment, referring to FIG. 28, FIG. 28 is a three-dimensional view of the sliding mechanism 233 shown in FIG. 25 from another perspective. The damping assembly 3 further includes a third concave-convex surface region 37. The third concave-convex surface region 37 is disposed on the second inner surface S2. The third concave-convex surface region 37 also includes a plurality of concave surface portions a spaced apart in the Y-axis direction, and a convex surface portion b is formed between two adjacent concave surface portions a. A distance between two adjacent concave surface portions a of the third concave-convex surface region 37 is equal to the distance between two adjacent concave surface portions a of the first concave-convex surface region 33, and the third concave-convex surface region 37 and the first concave-convex surface region 33 are arranged in alignment with each other in the Y-axis direction, to be specific, the plurality of concave surface portions a of the third concave-convex surface region 37 and the plurality of concave surface portions a of the first concave-convex surface region 33 are respectively arranged in alignment with each other in the Y-axis direction. On the basis of this, the third pressing member 315 specifically fits with the third concave-convex surface region 37 on the second inner surface S2.

In this way, in the damping assembly 3, in addition to generating a friction force through fitting between the first elastic structure 31 and the first concave-convex surface region 33, a friction force is generated through fitting between the first elastic structure 31 and the third concave-convex surface region 37, so that the damping function of the damping assembly 3 can be further improved. In addition, two opposite sides of the sliding member 2 are subjected to friction forces at the same time. In the process of sliding relative to the sliding rail 1, the sliding member 2 has relatively good stability, to prevent the sliding member 2 from being tilted or even stuck.

On the basis of the foregoing embodiment, structures of the second elastic structure 32 and the first elastic structure 31 may be the same or different. This embodiment provides descriptions by using an example in which the structures of the second elastic structure 32 and the first elastic structure 31 are the same. This cannot be considered as a special limitation on this application. On the basis of this, the third pressing member 315 in the second elastic structure 32 also fits with the third concave-convex surface region 37.

The foregoing embodiments provide descriptions by using an example in which the first concave-convex surface region 33 and the second concave-convex surface region 34 are arranged in alignment with each other in the Y-axis direction and the second distance D₂ meets the condition: D₂=(K+1/2)×D₁. In this embodiment, continuity and stability of the friction force F_{friction} can be improved. Certainly, to achieve this objective, there may be another embodiment.

For example, referring to FIG. 29, FIG. 29 is a schematic diagram of a relative position between the sliding member 2 and the first elastic structure 31 and a relative position between the sliding member 2 and the second elastic structure 32 in the sliding mechanism 233 according to some other embodiments of this application. In this embodiment, the second distance D₂ meets the condition: D₂=M×D₁. However, the first concave-convex surface region 33 and the second concave-convex surface region 34 are arranged in a staggered manner in the Y-axis direction, and a staggering amount D_{d} between the first concave-convex surface region 33 and the second concave-convex surface region 34 meets a condition: Da=(N+1/2)×D₁. M and N are 0 or positive integers greater than 0. In the embodiment shown in FIG. 29, M=3, and N=1. In addition, it should be noted that "D₂=M×D₁" is not limited to absolute equality between D₂ and M×D₁, and when an absolute value of a difference between D₂ and M×D₁ is less than or equal to D₁/8, it may be considered that the second distance D₂ meets the condition: D₂=M×D₁. Similarly, "D_{d}=(N+1/2)×D₁" is not limited to absolute equality between D_{d} and (N+1/2)×D₁, and when an absolute value of a difference between D_{d} and (N+1/2)×D₁ is less than or equal to D₁/8, it may be considered that the staggering amount D_{d} meets the condition: Da=(N+1/2)×D₁.

In this way, when the sliding member 2 slides relative to the sliding rail 1, the first elastic structure 31 slides along the first concave-convex surface region 33, and the second elastic structure 32 slides along the second concave-convex surface region 34. In addition, when the first elastic structure 31 fits with the concave surface portion a, the second elastic structure 32 fits with the convex surface portion b, and when the first elastic structure 31 fits with the convex surface portion b, the second elastic structure 32 fits with the concave surface portion a. At a moment shown in FIG. 29, the first elastic structure 31 fits with the convex surface portion b, and the second elastic structure 32 fits with the concave surface portion a. Therefore, the alternate fitting can also improve continuity and stability of the friction force F_{friction}. This arrangement manner is simple and easy to implement.

On the basis of any one of the foregoing embodiments, optionally, the quantity of first elastic structures 31 may be equal to the quantity of second elastic structures 32. In this way, in the process in which the sliding member 2 slides relative to the sliding rail 1, friction forces generated when the first elastic structure 31 and the second elastic structure 32 alternately fit with the concave surface portion a are equal. Therefore, continuity and stability of the friction force F_{friction} can be further improved.

On the basis of any one of the foregoing embodiments, optionally, surface roughness of the concave surface portion a may be greater than or equal to 0.2 and less than or equal to 0.6. Specifically, the surface roughness of the concave surface portion a may be 0.2, 0.3, 0.4, 0.5, or 0.6. Surface roughness of the convex surface portion b may be greater than or equal to 0.1 and less than or equal to 0.3. Specifically, the surface roughness of the convex surface portion b may be 0.1, 0.2, or 0.3. In this way, roughness of the first concave-convex surface region 33 and the second concave-convex surface region 34 is moderate, thereby facilitating application in a 3C product.

In the foregoing embodiment, to obtain the concave surface portion a with relatively large roughness through machining, the concave surface portion a may be machined through electrical discharge machining, to increase the surface roughness.

It can be learned from the foregoing formula Friction force F_{friction}=µF_{N} that a magnitude of the friction force F_{friction} can be adjusted by adjusting the roughness of the first concave-convex surface region 33 and the second concave-convex surface region 34, the quantity of first elastic structures 31, and the quantity of second elastic structures 32.

For example, referring to the following Table 1, there are eight elastic structures (including the first elastic structure 31 and the second elastic structure 32), an elastic force existing when the elastic structure fits with the concave surface portion a is 0 N, and an elastic force existing when the elastic structure fits with the convex surface portion b is 96 N. Roughness of the concave surface portion a is 0.6, and roughness of the convex surface portion b is 0.3. In this case, a sum of friction forces generated by the eight elastic structures is greater than or equal to 330 N and less than 350 N. Therefore, in an actual application, roughness of the concave-convex surface region and a quantity of elastic structures may be designed with reference to a specific application scenario. This is not limited herein.

**Table 1**

| Quantity of elastic structures | Elastic force between the elastic structure and a convex surface portion | Elastic force between the elastic structure and a concave surface portion | Roughness of the concave surface portion | Roughness of the convex surface portion | Sum of friction forces of the elastic structures |
|---|---|---|---|---|---|
| 8 | 96 N | 0 N | 0.6 | 0.3 | 330-350 N |

The foregoing embodiments describe a plurality of structural forms of the sliding mechanism 233 provided in this application. The sliding mechanism 233 may be applied to the rotating shaft apparatus in the foregoing foldable-screen terminal, or may be applied to another component of the foldable-screen terminal, or may be applied to another electronic device, an industrial transmission system, or a drawer sliding rail of a home or office device such as a desk or a computer table, or the sliding mechanism 233 may be used as an independent product. This is not specifically limited in this application.

In the descriptions of this specification, specific features, structures, materials, or characteristics may be properly combined in any one or more embodiments or examples.

Finally, it should be noted that the foregoing embodiments are only used to describe the technical solutions in this application, but are not used to limit this application. Although this application has been described in detail with reference to the foregoing embodiments, it should be understood by a person of ordinary skill in the art that the technical solutions described in the foregoing embodiments may still be modified without departing from the scope of the technical solution as defined in the appended claims.

## Claims

1. A foldable-screen terminal (100), comprising a first housing (21), a second housing (22), and a rotating shaft apparatus (23) connected between the first housing (21) and the second housing (22), the rotating shaft apparatus (23) comprising a sliding mechanism (233), wherein the sliding mechanism (233) comprising:
a sliding rail (1), wherein an extension direction of the sliding rail (1) is a first direction;
a sliding member (2), wherein the sliding member (2) is in sliding fit with the sliding rail (1); and
a damping assembly (3), **characterized in that** the damping assembly (3) comprises a first elastic structure (31), a second elastic structure (32), a first concave-convex surface region (33), and a second concave-convex surface region (34), wherein
one of the first elastic structure (31) and the first concave-convex surface region (33) is disposed on the sliding rail (1) and the other thereof is disposed on the sliding member (2), and the first elastic structure (31) fits with the first concave-convex surface region (33); and one of the second elastic structure (32) and the second concave-convex surface region (34) is disposed on the sliding rail (1) and the other thereof is disposed on the sliding member (2), and the second elastic structure (32) fits with the second concave-convex surface region (34);
the first concave-convex surface region (33) and the second concave-convex surface region (34) each comprise a plurality of concave surface portions spaced apart in the first direction, and a convex surface portion is formed between two adjacent concave surface portions; and
in a process in which the sliding member (2) slides relative to the sliding rail (1), when the first elastic structure (31) fits with the concave surface portion of the first concave-convex surface region (33), the second elastic structure (32) fits with a convex surface portion of the second concave-convex surface region (34); and when the first elastic structure (31) fits with a convex surface portion of the first concave-convex surface region (33), the second elastic structure (32) fits with the concave surface portion of the second concave-convex surface region (34).

2. The foldable-screen terminal (100) according to claim 1, wherein a distance between two adjacent concave surface portions of the first concave-convex surface region (33) is equal to a distance between two adjacent concave surface portions of the second concave-convex surface region (34); and the distance between two adjacent concave surface portions of the first concave-convex surface region (33) and the second concave-convex surface region (34) is a first distance D₁, and a distance between the first elastic structure (31) and the second elastic structure (32) in the first direction is a second distance D₂; and
the first concave-convex surface region (33) and the second concave-convex surface region (34) are arranged in alignment with each other in the first direction, and the second distance D₂ meets a condition: D₂=(K+1/2)×D₁, wherein
K is 0 or a positive integer greater than 0.

3. The foldable-screen terminal (100) according to claim 1 or 2, wherein the sliding rail (1) is provided with a sliding groove (C), the sliding groove (C) comprises a first inner surface (S1), and the first inner surface (S1) is parallel to the first direction;
at least a part of the sliding member (2) is in sliding fit with the sliding groove (C), the at least a part comprises a first side surface (S4), and the first side surface (S4) and the first inner surface (S1) face each other;
the sliding rail (1) comprises a first limiting portion (11), the first limiting portion (11) is located on a side that is of the first inner surface (S1) and that is away from the first side surface (S4), and the first inner surface (S1) is formed on the first limiting portion (11); and
the first elastic structure (31) and the second elastic structure (32) are disposed on the first limiting portion (11), and the first concave-convex surface region (33) and the second concave-convex surface region (34) are disposed on the first side surface (S4); or
the first elastic structure (31) and the second elastic structure (32) are disposed on the at least a part, and the first concave-convex surface region (33) and the second concave-convex surface region (34) are disposed on the first inner surface (S1).

4. The foldable-screen terminal (100) according to claim 3, wherein the first concave-convex surface region (33) and the second concave-convex surface region (34) are spaced apart in a second direction, the second direction is perpendicular to the first direction, and the second direction is parallel to the first side surface (S4); and
the first elastic structure (31) and the second elastic structure (32) are spaced apart in the second direction.

5. The foldable-screen terminal (100) according to claim 4, wherein there are a plurality of first elastic structures (31), and the plurality of first elastic structures (31) are successively arranged in the first direction; and all of the plurality of first elastic structures (31) fit with the concave surface portions of the first concave-convex surface region (33), or all of the plurality of first elastic structures (31) fit with convex surface portions of the first concave-convex surface region (33);
there are a plurality of second elastic structures (32), and the plurality of second elastic structures (32) are successively arranged in the second direction; and all of the plurality of second elastic structures (32) fit with convex surface portions of the second concave-convex surface region (34), or all of the plurality of second elastic structures (32) fit with the concave surface portions of the second concave-convex surface region (34); and
in the process in which the sliding member (2) slides relative to the sliding rail (1), when the plurality of first elastic structures (31) fit with the concave surface portions of the first concave-convex surface region (33), the plurality of second elastic structures (32) fit with the convex surface portions of the second concave-convex surface region (34); and when the plurality of first elastic structures (31) fit with the convex surface portions of the first concave-convex surface region (33), the plurality of second elastic structures (32) fit with the concave surface portions of the second concave-convex surface region (34).

6. The foldable-screen terminal (100) according to any one of claims 3-5, wherein the plurality of concave surface portions of the first concave-convex surface region (33) are respectively aligned with and connected to the plurality of concave surface portions of the second concave-convex surface region (34) to form an integral concave surface portion, and the plurality of convex surface portions of the first concave-convex surface region (33) are respectively aligned with and connected to the plurality of convex surface portions of the second concave-convex surface region (34) to form an integral convex surface portion.

7. The foldable-screen terminal (100) according to claim 3, wherein the first concave-convex surface region (33) and the second concave-convex surface region (34) are a same concave-convex surface region, and the first elastic structure (31) and the second elastic structure (32) are arranged in a row in the first direction.

8. The foldable-screen terminal (100) according to claim 7, wherein there is at least one first elastic structure (31), there is at least one second elastic structure (32), and the at least one first elastic structure (31) and the at least one second elastic structure (32) are successively alternately arranged in the first direction.

9. The foldable-screen terminal (100) according to claim 3, wherein the first elastic structure (31) is disposed on the first limiting portion (11), and the first concave-convex surface region (33) is disposed on the first side surface (S4); and
the first elastic structure (31) comprises:
a base (311), wherein the base (311) is disposed on the first limiting portion (11), the base (311) is provided with a sliding hole (3111), one end of the sliding hole (3111) is closed to form a closed end, the other end of the sliding hole (3111) is opened to form an open end, and the open end is located on a side that is of the closed end and that faces the first concave-convex surface region (33);
a first pressing member (312), wherein the first pressing member (312) is disposed in the sliding hole (3111) and is capable of sliding along the sliding hole (3111), and a part of the first pressing member (312) projects from the open end; and
a first elastic member (313), wherein the first elastic member (313) is disposed in the sliding hole (3111) and is located between the closed end and the first pressing member (312), and the part that is of the first pressing member (312) and that projects from the open end fits with the first concave-convex surface region (33).

10. The foldable-screen terminal (100) according to claim 9, wherein the first limiting portion (11) is provided with a first threaded hole (11a), and an end of the first threaded hole (11a) penetrates the first inner surface (S1); and
a first external thread (3112) is disposed on an outer circumference of the base (311), an axial direction of the first external thread (3112) is parallel to an axial direction of the sliding hole (3111), the base (311) is accommodated in the first threaded hole (11a), and the first external thread (3112) is in threaded fit with the first threaded hole (11a).

11. The foldable-screen terminal (100) according to claim 10, wherein the base (311) comprises:
a base body (311a), wherein the first external thread (3112) and the sliding hole (3111) are disposed on the base body (311a), the base body (311a) is further provided with an inner hole (3113), the inner hole (3113) is located on a side that is of the closed end and that is away from the open end, the inner hole (3113) and the sliding hole (3111) are coaxially disposed and communicate with each other, and an end that is of the inner hole (3113) and that is away from the sliding hole (3111) penetrates the base body (311a); and
a fastening member (311b), wherein the fastening member (311b) is disposed in the inner hole (3113).

12. The foldable-screen terminal (100) according to claim 11, wherein the inner hole (3113) is a second threaded hole, a second external thread (311b1) is disposed on an outer circumference of the fastening member (311b), and the second external thread (311b1) is in threaded fit with the second threaded hole.

13. The foldable-screen terminal (100) according to claim 12, wherein the first limiting portion (11) further comprises a first outer surface (S7), the first outer surface (S7) and the first inner surface (S1) face away from each other, and the first threaded hole (11a) penetrates the first outer surface (S7); and
an end surface that is of the fastening member (311b) and that is away from the sliding hole (3111) is provided with an operating slot (311b2), and the operating slot (311b2) is a non-circular slot.

14. The foldable-screen terminal (100) according to claim 13, wherein rotation directions of the first external thread (3112) and the second external thread (311b1) are opposite to each other.

15. The foldable-screen terminal (100) according to claim 3, wherein the first elastic structure (31) is disposed on the at least a part, and the first concave-convex surface region (33) is disposed on the first inner surface (S1);
the at least a part further comprises a second side surface (S5), the second side surface (S5) and the first side surface (S4) face away from each other, the sliding groove (C) further comprises a second inner surface (S2), and the second inner surface (S2) and the second side surface (S5) face each other; and
the first elastic structure (31) comprises:
a base (311), wherein the base (311) is disposed on the at least a part, the base (311) is provided with a sliding hole (3111), one end of the sliding hole (3111) is opened to form a first open end, the other end of the sliding hole (3111) is opened to form a second open end, the first open end faces the first inner surface (S1), and the second open end faces the second inner surface (S2);
a second pressing member (314), wherein the second pressing member (314) is disposed in the sliding hole (3111) and is capable of sliding along the sliding hole (3111), and a part of the second pressing member (314) projects from the first open end;
a third pressing member (315), wherein the third pressing member (315) is disposed in the sliding hole (3111) and is capable of sliding along the sliding hole (3111), and a part of the third pressing member (315) projects from the second open end; and
a second elastic member (316), wherein the second elastic member (316) is disposed in the sliding hole (3111) and is located between the second pressing member (314) and the third pressing member (315), the second pressing member (314) fits with the first concave-convex surface region (33), and the third pressing member (315) fits with the second inner surface (S2).

## Patentansprüche

1. Endgerät (100) mit faltbarem Bildschirm, umfassend ein erstes Gehäuse (21), ein zweites Gehäuse (22) und eine Drehwellenvorrichtung (23), die zwischen dem ersten Gehäuse (21) und dem zweiten Gehäuse (22) verbunden ist, wobei die Drehwellenvorrichtung (23) einen Gleitmechanismus (233) umfasst, wobei der Gleitmechanismus (233) umfasst:
eine Gleitschiene (1), wobei eine Erstreckungsrichtung der Gleitschiene (1) eine erste Richtung ist;
ein Gleitelement (2), wobei das Gleitelement (2) in Gleitpassung mit der Gleitschiene (1) steht; und
eine Dämpfungsanordnung (3), **dadurch gekennzeichnet, dass** die Dämpfungsanordnung (3) eine erste elastische Struktur (31), eine zweite elastische Struktur (32), einen ersten konkav-konvexen Oberflächenbereich (33) und einen zweiten konkav-konvexen Oberflächenbereich (34) umfasst, wobei
eines von der ersten elastischen Struktur (31) und dem ersten konkav-konvexen Oberflächenbereich (33) an der Gleitschiene (1) angeordnet ist und das andere davon an dem Gleitelement (2) angeordnet ist, und die erste elastische Struktur (31) mit dem ersten konkav-konvexen Oberflächenbereich (33) in Eingriff steht; und eines von der zweiten elastischen Struktur (32) und dem zweiten konkav-konvexen Oberflächenbereich (34) an der Gleitschiene (1) angeordnet ist und das andere davon an dem Gleitelement (2) angeordnet ist, und die zweite elastische Struktur (32) mit dem zweiten konkav-konvexen Oberflächenbereich (34) in Eingriff steht;
der erste konkav-konvexe Oberflächenbereich (33) und der zweite konkav-konvexe Oberflächenbereich (34) jeweils eine Vielzahl von konkaven Oberflächenabschnitten umfassen, die in der ersten Richtung voneinander beabstandet sind, und ein konvexer Oberflächenabschnitt zwischen zwei benachbarten konkaven Oberflächenabschnitten ausgebildet ist; und
in einem Prozess, in dem das Gleitelement (2) relativ zur Gleitschiene (1) gleitet, wenn die erste elastische Struktur (31) mit dem konkaven Oberflächenabschnitt des ersten konkav-konvexen Oberflächenbereichs (33) in Eingriff steht, die zweite elastische Struktur (32) mit einem konvexen Oberflächenabschnitt des zweiten konkav-konvexen Oberflächenbereichs (34) in Eingriff steht; und wenn die erste elastische Struktur (31) mit einem konvexen Oberflächenabschnitt des ersten konkav-konvexen Oberflächenbereichs (33) in Eingriff steht, die zweite elastische Struktur (32) mit dem konkaven Oberflächenabschnitt des zweiten konkav-konvexen Oberflächenbereichs (34) in Eingriff steht.

2. Endgerät (100) mit faltbarem Bildschirm nach Anspruch 1, wobei ein Abstand zwischen zwei benachbarten konkaven Oberflächenabschnitten des ersten konkav-konvexen Oberflächenbereichs (33) gleich einem Abstand zwischen zwei benachbarten konkaven Oberflächenabschnitten des zweiten konkav-konvexen Oberflächenbereichs (34) ist; und der Abstand zwischen zwei benachbarten konkaven Oberflächenabschnitten des ersten konkav-konvexen Oberflächenbereichs (33) und des zweiten konkav-konvexen Oberflächenbereichs (34) ein erster Abstand D₁ ist, und ein Abstand zwischen der ersten elastischen Struktur (31) und der zweiten elastischen Struktur (32) in der ersten Richtung ein zweiter Abstand D₂ ist; und
der erste konkav-konvexe Oberflächenbereich (33) und der zweite konkav-konvexe Oberflächenbereich (34) in Ausrichtung miteinander in der ersten Richtung angeordnet sind und der zweite Abstand D₂ eine Bedingung erfüllt: D₂=(K+1/2)×D₁, wobei
K 0 oder eine positive Ganzzahl größer als 0 ist.

3. Endgerät (100) mit faltbarem Bildschirm nach Anspruch 1 oder 2, wobei die Gleitschiene (1) mit einer Gleitnut (C) versehen ist, die Gleitnut (C) eine erste Innenfläche (S1) umfasst und die erste Innenfläche (S1) parallel zur ersten Richtung ist;
zumindest ein Teil des Gleitelements (2) in Gleitpassung mit der Gleitnut (C) steht, der zumindest eine Teil eine erste Seitenfläche (S4) umfasst und die erste Seitenfläche (S4) und die erste Innenfläche (S1) einander zugewandt sind;
die Gleitschiene (1) einen ersten Begrenzungsabschnitt (11) umfasst, der erste Begrenzungsabschnitt (11) auf einer Seite angeordnet ist, die von der ersten Innenfläche (S1) aus gesehen von der ersten Seitenfläche (S4) abgewandt ist, und die erste Innenfläche (S1) an dem ersten Begrenzungsabschnitt (11) ausgebildet ist; und
die erste elastische Struktur (31) und die zweite elastische Struktur (32) an dem ersten Begrenzungsabschnitt (11) angeordnet sind und der erste konkav-konvexe Oberflächenbereich (33) und der zweite konkav-konvexe Oberflächenbereich (34) an der ersten Seitenfläche (S4) angeordnet sind; oder
die erste elastische Struktur (31) und die zweite elastische Struktur (32) an dem zumindest einen Teil angeordnet sind und der erste konkav-konvexe Oberflächenbereich (33) und der zweite konkav-konvexe Oberflächenbereich (34) an der ersten Innenfläche (S1) angeordnet sind.

4. Endgerät (100) mit faltbarem Bildschirm nach Anspruch 3, wobei der erste konkav-konvexe Oberflächenbereich (33) und der zweite konkav-konvexe Oberflächenbereich (34) in einer zweiten Richtung voneinander beabstandet sind, wobei die zweite Richtung senkrecht zur ersten Richtung ist und die zweite Richtung parallel zur ersten Seitenfläche (S4) ist; und
die erste elastische Struktur (31) und die zweite elastische Struktur (32) in der zweiten Richtung voneinander beabstandet sind.

5. Endgerät (100) mit faltbarem Bildschirm nach Anspruch 4, wobei eine Vielzahl von ersten elastischen Strukturen (31) vorhanden ist und die Vielzahl von ersten elastischen Strukturen (31) nacheinander in der ersten Richtung angeordnet ist; und alle der Vielzahl von ersten elastischen Strukturen (31) mit den konkaven Oberflächenabschnitten des ersten konkav-konvexen Oberflächenbereichs (33) in Eingriff stehen, oder alle der Vielzahl von ersten elastischen Strukturen (31) mit konvexen Oberflächenabschnitten des ersten konkav-konvexen Oberflächenbereichs (33) in Eingriff stehen;
eine Vielzahl von zweiten elastischen Strukturen (32) vorhanden ist und die Vielzahl von zweiten elastischen Strukturen (32) nacheinander in der zweiten Richtung angeordnet ist; und alle der Vielzahl von zweiten elastischen Strukturen (32) mit konvexen Oberflächenabschnitten des zweiten konkav-konvexen Oberflächenbereichs (34) in Eingriff stehen, oder alle der Vielzahl von zweiten elastischen Strukturen (32) mit den konkaven Oberflächenabschnitten des zweiten konkav-konvexen Oberflächenbereichs (34) in Eingriff stehen; und
in dem Prozess, in dem das Gleitelement (2) relativ zur Gleitschiene (1) gleitet, wenn die Vielzahl von ersten elastischen Strukturen (31) mit den konkaven Oberflächenabschnitten des ersten konkav-konvexen Oberflächenbereichs (33) in Eingriff stehen, die Vielzahl von zweiten elastischen Strukturen (32) mit den konvexen Oberflächenabschnitten des zweiten konkav-konvexen Oberflächenbereichs (34) in Eingriff stehen; und wenn die Vielzahl von ersten elastischen Strukturen (31) mit den konvexen Oberflächenabschnitten des ersten konkav-konvexen Oberflächenbereichs (33) in Eingriff stehen, die Vielzahl von zweiten elastischen Strukturen (32) mit den konkaven Oberflächenabschnitten des zweiten konkav-konvexen Oberflächenbereichs (34) in Eingriff stehen.

6. Endgerät (100) mit faltbarem Bildschirm nach einem der Ansprüche 3-5, wobei die Vielzahl von konkaven Oberflächenabschnitten des ersten konkav-konvexen Oberflächenbereichs (33) jeweils mit der Vielzahl von konkaven Oberflächenabschnitten des zweiten konkav-konvexen Oberflächenbereichs (34) ausgerichtet und verbunden ist, um einen integralen konkaven Oberflächenabschnitt zu bilden, und die Vielzahl von konvexen Oberflächenabschnitten des ersten konkav-konvexen Oberflächenbereichs (33) jeweils mit der Vielzahl von konvexen Oberflächenabschnitten des zweiten konkav-konvexen Oberflächenbereichs (34) ausgerichtet und verbunden ist, um einen integralen konvexen Oberflächenabschnitt zu bilden.

7. Endgerät (100) mit faltbarem Bildschirm nach Anspruch 3, wobei der erste konkav-konvexe Oberflächenbereich (33) und der zweite konkav-konvexe Oberflächenbereich (34) ein gleicher konkav-konvexer Oberflächenbereich sind und die erste elastische Struktur (31) und die zweite elastische Struktur (32) in einer Reihe in der ersten Richtung angeordnet sind.

8. Endgerät (100) mit faltbarem Bildschirm nach Anspruch 7, wobei mindestens eine erste elastische Struktur (31) vorhanden ist, mindestens eine zweite elastische Struktur (32) vorhanden ist und die mindestens eine erste elastische Struktur (31) und die mindestens eine zweite elastische Struktur (32) nacheinander abwechselnd in der ersten Richtung angeordnet sind.

9. Endgerät (100) mit faltbarem Bildschirm nach Anspruch 3, wobei die erste elastische Struktur (31) an dem ersten Begrenzungsabschnitt (11) angeordnet ist und der erste konkav-konvexe Oberflächenbereich (33) an der ersten Seitenfläche (S4) angeordnet ist; und
die erste elastische Struktur (31) umfasst:
eine Basis (311), wobei die Basis (311) an dem ersten Begrenzungsabschnitt (11) angeordnet ist, die Basis (311) mit einem Gleitloch (3111) versehen ist, ein Ende des Gleitlochs (3111) geschlossen ist, um ein geschlossenes Ende zu bilden, das andere Ende des Gleitlochs (3111) offen ist, um ein offenes Ende zu bilden, und das offene Ende auf einer Seite angeordnet ist, die von dem geschlossenen Ende aus gesehen dem ersten konkav-konvexen Oberflächenbereich (33) zugewandt ist;
ein erstes Druckelement (312), wobei das erste Druckelement (312) in dem Gleitloch (3111) angeordnet ist und in der Lage ist, entlang des Gleitlochs (3111) zu gleiten, und ein Teil des ersten Druckelements (312) aus dem offenen Ende herausragt; und
ein erstes elastisches Element (313), wobei das erste elastische Element (313) in dem Gleitloch (3111) angeordnet ist und sich zwischen dem geschlossenen Ende und dem ersten Druckelement (312) befindet, und der Teil, der von dem ersten Druckelement (312) aus dem offenen Ende herausragt, mit dem ersten konkav-konvexen Oberflächenbereich (33) in Eingriff steht.

10. Endgerät (100) mit faltbarem Bildschirm nach Anspruch 9, wobei der erste Begrenzungsabschnitt (11) mit einem ersten Gewindeloch (11a) versehen ist und ein Ende des ersten Gewindelochs (11a) die erste Innenfläche (S1) durchdringt; und
ein erstes Außengewinde (3112) an einem Außenumfang der Basis (311) angeordnet ist, eine axiale Richtung des ersten Außengewindes (3112) parallel zu einer axialen Richtung des Gleitlochs (3111) ist, die Basis (311) in dem ersten Gewindeloch (11a) aufgenommen ist und das erste Außengewinde (3112) in Gewindepassung mit dem ersten Gewindeloch (11a) steht.

11. Endgerät (100) mit faltbarem Bildschirm nach Anspruch 10, wobei die Basis (311) umfasst:
einen Basiskörper (311a), wobei das erste Außengewinde (3112) und das Gleitloch (3111) an dem Basiskörper (311a) angeordnet sind, der Basiskörper (311a) ferner mit einem Innenloch (3113) versehen ist, das Innenloch (3113) auf einer Seite angeordnet ist, die von dem geschlossenen Ende aus gesehen von dem offenen Ende abgewandt ist, das Innenloch (3113) und das Gleitloch (3111) koaxial angeordnet sind und miteinander kommunizieren, und ein Ende, das von dem Innenloch (3113) aus gesehen von dem Gleitloch (3111) abgewandt ist, den Basiskörper (311a) durchdringt; und
ein Befestigungselement (311b), wobei das Befestigungselement (311b) in dem Innenloch (3113) angeordnet ist.

12. Endgerät (100) mit faltbarem Bildschirm nach Anspruch 11, wobei das Innenloch (3113) ein zweites Gewindeloch ist, ein zweites Außengewinde (311b1) an einem Außenumfang des Befestigungselements (311b) angeordnet ist und das zweite Außengewinde (311b1) in Gewindepassung mit dem zweiten Gewindeloch steht.

13. Endgerät (100) mit faltbarem Bildschirm nach Anspruch 12, wobei der erste Begrenzungsabschnitt (11) ferner eine erste Außenfläche (S7) umfasst, wobei die erste Außenfläche (S7) und die erste Innenfläche (S1) voneinander abgewandt sind und das erste Gewindeloch (11a) die erste Außenfläche (S7) durchdringt; und
eine Endfläche, die von dem Befestigungselement (311b) aus gesehen von dem Gleitloch (3111) abgewandt ist, mit einem Betätigungsschlitz (311b2) versehen ist und der Betätigungsschlitz (311b2) ein nicht kreisförmiger Schlitz ist.

14. Endgerät (100) mit faltbarem Bildschirm nach Anspruch 13, wobei Drehrichtungen des ersten Außengewindes (3112) und des zweiten Außengewindes (311b1) einander entgegengesetzt sind.

15. Endgerät (100) mit faltbarem Bildschirm nach Anspruch 3, wobei die erste elastische Struktur (31) an dem zumindest einen Teil angeordnet ist und der erste konkav-konvexe Oberflächenbereich (33) an der ersten Innenfläche (S1) angeordnet ist;
der zumindest eine Teil ferner eine zweite Seitenfläche (S5) umfasst, wobei die zweite Seitenfläche (S5) und die erste Seitenfläche (S4) voneinander abgewandt sind, die Gleitnut (C) ferner eine zweite Innenfläche (S2) umfasst und die zweite Innenfläche (S2) und die zweite Seitenfläche (S5) einander zugewandt sind; und
die erste elastische Struktur (31) umfasst:
eine Basis (311), wobei die Basis (311) an dem zumindest einen Teil angeordnet ist, die Basis (311) mit einem Gleitloch (3111) versehen ist, ein Ende des Gleitlochs (3111) offen ist, um ein erstes offenes Ende zu bilden, das andere Ende des Gleitlochs (3111) offen ist, um ein zweites offenes Ende zu bilden, das erste offene Ende der ersten Innenfläche (S1) zugewandt ist und das zweite offene Ende der zweiten Innenfläche (S2) zugewandt ist;
ein zweites Druckelement (314), wobei das zweite Druckelement (314) in dem Gleitloch (3111) angeordnet ist und in der Lage ist, entlang des Gleitlochs (3111) zu gleiten, und ein Teil des zweiten Druckelements (314) aus dem ersten offenen Ende herausragt;
ein drittes Druckelement (315), wobei das dritte Druckelement (315) in dem Gleitloch (3111) angeordnet ist und in der Lage ist, entlang des Gleitlochs (3111) zu gleiten, und ein Teil des dritten Druckelements (315) aus dem zweiten offenen Ende herausragt; und
ein zweites elastisches Element (316), wobei das zweite elastische Element (316) in dem Gleitloch (3111) angeordnet ist und sich zwischen dem zweiten Druckelement (314) und dem dritten Druckelement (315) befindet, das zweite Druckelement (314) mit dem ersten konkav-konvexen Oberflächenbereich (33) in Eingriff steht, und das dritte Druckelement (315) mit der zweiten Innenfläche (S2) in Eingriff steht.

## Revendications

1. Terminal à écran pliable (100), comprenant un premier boîtier (21), un second boîtier (22), et un appareil à arbre rotatif (23) connecté entre le premier boîtier (21) et le second boîtier (22), l'appareil à arbre rotatif (23) comprenant un mécanisme de coulissement (233), dans lequel le mécanisme de coulissement (233) comprend :
un rail de coulissement (1), dans lequel une direction d'extension du rail de coulissement (1) est une première direction ;
un élément coulissant (2), dans lequel l'élément coulissant (2) est en ajustement coulissant avec le rail de coulissement (1) ; et
un ensemble d'amortissement (3), **caractérisé en ce que** l'ensemble d'amortissement (3) comprend une première structure élastique (31), une seconde structure élastique (32), une première région de surface concave-convexe (33), et une seconde région de surface concave-convexe (34), dans lequel
l'une de la première structure élastique (31) et de la première région de surface concave-convexe (33) est disposée sur le rail de coulissement (1) et l'autre de celles-ci est disposée sur l'élément coulissant (2), et la première structure élastique (31) vient en prise avec la première région de surface concave-convexe (33) ; et l'une de la seconde structure élastique (32) et de la seconde région de surface concave-convexe (34) est disposée sur le rail de coulissement (1) et l'autre de celles-ci est disposée sur l'élément coulissant (2), et la seconde structure élastique (32) vient en prise avec la seconde région de surface concave-convexe (34) ;
la première région de surface concave-convexe (33) et la seconde région de surface concave-convexe (34) comprennent chacune une pluralité de parties de surface concaves espacées dans la première direction, et une partie de surface convexe est formée entre deux parties de surface concaves adjacentes ; et
dans un processus dans lequel l'élément coulissant (2) coulisse par rapport au rail de coulissement (1), lorsque la première structure élastique (31) vient en prise avec la partie de surface concave de la première région de surface concave-convexe (33), la seconde structure élastique (32) vient en prise avec une partie de surface convexe de la seconde région de surface concave-convexe (34) ; et lorsque la première structure élastique (31) vient en prise avec une partie de surface convexe de la première région de surface concave-convexe (33), la seconde structure élastique (32) vient en prise avec la partie de surface concave de la seconde région de surface concave-convexe (34).

2. Terminal à écran pliable (100) selon la revendication 1, dans lequel une distance entre deux parties de surface concaves adjacentes de la première région de surface concave-convexe (33) est égale à une distance entre deux parties de surface concaves adjacentes de la seconde région de surface concave-convexe (34) ; et la distance entre deux parties de surface concaves adjacentes de la première région de surface concave-convexe (33) et de la seconde région de surface concave-convexe (34) est une première distance D₁, et une distance entre la première structure élastique (31) et la seconde structure élastique (32) dans la première direction est une seconde distance D₂ ; et
la première région de surface concave-convexe (33) et la seconde région de surface concave-convexe (34) sont agencées en alignement l'une avec l'autre dans la première direction, et la seconde distance D₂ remplit une condition : D₂=(K+1/2)×D₁, dans lequel
K est 0 ou un entier positif supérieur à 0.

3. Terminal à écran pliable (100) selon la revendication 1 ou 2, dans lequel le rail de coulissement (1) est pourvu d'une rainure de coulissement (C), la rainure de coulissement (C) comprend une première surface intérieure (S1), et la première surface intérieure (S1) est parallèle à la première direction ;
au moins une partie de l'élément coulissant (2) est en ajustement coulissant avec la rainure de coulissement (C), l'au moins une partie comprend une première surface latérale (S4), et la première surface latérale (S4) et la première surface intérieure (S1) se font face ;
le rail de coulissement (1) comprend une première partie de limitation (11), la première partie de limitation (11) est située sur un côté qui est de la première surface intérieure (S1) et qui est éloigné de la première surface latérale (S4), et la première surface intérieure (S1) est formée sur la première partie de limitation (11) ; et
la première structure élastique (31) et la seconde structure élastique (32) sont disposées sur la première partie de limitation (11), et la première région de surface concave-convexe (33) et la seconde region de surface concave-convexe (34) sont disposées sur la première surface latérale (S4) ; ou
la première structure élastique (31) et la seconde structure élastique (32) sont disposées sur l'au moins une partie, et la première région de surface concave-convexe (33) et la seconde région de surface concave-convexe (34) sont disposées sur la première surface intérieure (S1).

4. Terminal à écran pliable (100) selon la revendication 3, dans lequel la première région de surface concave-convexe (33) et la seconde région de surface concave-convexe (34) sont espacées dans une seconde direction, la seconde direction est perpendiculaire à la première direction, et la seconde direction est parallèle à la première surface latérale (S4) ; et
la première structure élastique (31) et la seconde structure élastique (32) sont espacées dans la seconde direction.

5. Terminal à écran pliable (100) selon la revendication 4, dans lequel il existe une pluralité de premières structures élastiques (31), et la pluralité de premières structures élastiques (31) sont agencées successivement dans la première direction ; et la totalité de la pluralité de premières structures élastiques (31) viennent en prise avec les parties de surface concaves de la première région de surface concave-convexe (33), ou la totalité de la pluralité de premières structures élastiques (31) viennent en prise avec les parties de surface convexes de la première région de surface concave-convexe (33) ;
il existe une pluralité de secondes structures élastiques (32), et la pluralité de secondes structures élastiques (32) sont agencées successivement dans la seconde direction ; et la totalité de la pluralité de secondes structures élastiques (32) viennent en prise avec les parties de surface convexes de la seconde région de surface concave-convexe (34), ou la totalité de la pluralité de secondes structures élastiques (32) viennent en prise avec les parties de surface concaves de la seconde région de surface concave-convexe (34) ; et
dans le processus dans lequel l'élément coulissant (2) coulisse par rapport au rail de coulissement (1), lorsque la pluralité de premières structures élastiques (31) viennent en prise avec les parties de surface concaves de la première région de surface concave-convexe (33), la pluralité de secondes structures élastiques (32) viennent en prise avec les parties de surface convexes de la seconde région de surface concave-convexe (34) ; et lorsque la pluralité de premières structures élastiques (31) viennent en prise avec les parties de surface convexes de la première région de surface concave-convexe (33), la pluralité de secondes structures élastiques (32) viennent en prise avec les parties de surface concaves de la seconde région de surface concave-convexe (34).

6. Terminal à écran pliable (100) selon l'une quelconque des revendications 3-5, dans lequel la pluralité de parties de surface concaves de la première région de surface concave-convexe (33) sont respectivement alignées avec et connectées à la pluralité de parties de surface concaves de la seconde région de surface concave-convexe (34) pour former une partie de surface concave intégrale, et la pluralité de parties de surface convexes de la première région de surface concave-convexe (33) sont respectivement alignées avec et connectées à la pluralité de parties de surface convexes de la seconde région de surface concave-convexe (34) pour former une partie de surface convexe intégrale.

7. Terminal à écran pliable (100) selon la revendication 3, dans lequel la première région de surface concave-convexe (33) et la seconde région de surface concave-convexe (34) sont une même région de surface concave-convexe, et la première structure élastique (31) et la seconde structure élastique (32) sont agencées en une rangée dans la première direction.

8. Terminal à écran pliable (100) selon la revendication 7, dans lequel il existe au moins une première structure élastique (31), il existe au moins une seconde structure élastique (32), et l'au moins une première structure élastique (31) et l'au moins une seconde structure élastique (32) sont agencées successivement de manière alternée dans la première direction.

9. Terminal à écran pliable (100) selon la revendication 3, dans lequel la première structure élastique (31) est disposée sur la première partie de limitation (11), et la première région de surface concave-convexe (33) est disposée sur la première surface latérale (S4) ; et
la première structure élastique (31) comprend :
une base (311), dans lequel la base (311) est disposée sur la première partie de limitation (11), la base (311) est pourvue d'un trou de coulissement (3111), une extrémité du trou de coulissement (3111) est fermée pour former une extrémité fermée, l'autre extrémité du trou de coulissement (3111) est ouverte pour former une extrémité ouverte, et l'extrémité ouverte est située sur un côté qui est de l'extrémité fermée et qui fait face à la première région de surface concave-convexe (33) ;
un premier élément de pression (312), dans lequel le premier élément de pression (312) est disposé dans le trou de coulissement (3111) et est capable de coulisser le long du trou de coulissement (3111), et une partie du premier élément de pression (312) fait saillie depuis l'extrémité ouverte ; et
un premier élément élastique (313), dans lequel le premier élément élastique (313) est disposé dans le trou de coulissement (3111) et est situé entre l'extrémité fermée et le premier élément de pression (312), et la partie qui est du premier élément de pression (312) et qui fait saillie depuis l'extrémité ouverte vient en prise avec la première région de surface concave-convexe (33).

10. Terminal à écran pliable (100) selon la revendication 9, dans lequel la première partie de limitation (11) est pourvue d'un premier trou fileté (11a), et une extrémité du premier trou fileté (11a) traverse la première surface intérieure (S1) ; et
un premier filetage externe (3112) est disposé sur une circonférence externe de la base (311), une direction axiale du premier filetage externe (3112) est parallèle à une direction axiale du trou de coulissement (3111), la base (311) est logée dans le premier trou fileté (11a), et le premier filetage externe (3112) est en ajustement fileté avec le premier trou fileté (11a).

11. Terminal à écran pliable (100) selon la revendication 10, dans lequel la base (311) comprend :
un corps de base (311a), dans lequel le premier filetage externe (3112) et le trou de coulissement (3111) sont disposés sur le corps de base (311a), le corps de base (311a) est en outre pourvu d'un trou intérieur (3113), le trou intérieur (3113) est situé sur un côté qui est de l'extrémité fermée et qui est éloigné de l'extrémité ouverte, le trou intérieur (3113) et le trou de coulissement (3111) sont disposés de manière coaxiale et communiquent l'un avec l'autre, et une extrémité qui est du trou intérieur (3113) et qui est éloignée du trou de coulissement (3111) traverse le corps de base (311a) ; et
un élément de fixation (311b), dans lequel l'élément de fixation (311b) est disposé dans le trou intérieur (3113).

12. Terminal à écran pliable (100) selon la revendication 11, dans lequel le trou intérieur (3113) est un second trou fileté, un second filetage externe (311b1) est disposé sur une circonférence externe de l'élément de fixation (311b), et le second filetage externe (311b1) est en ajustement fileté avec le second trou fileté.

13. Terminal à écran pliable (100) selon la revendication 12, dans lequel la première partie de limitation (11) comprend en outre une première surface extérieure (S7), la première surface extérieure (S7) et la première surface intérieure (S1) sont orientées à l'opposé l'une de l'autre, et le premier trou fileté (11a) traverse la première surface extérieure (S7) ; et
une surface d'extrémité qui est de l'élément de fixation (311b) et qui est éloignée du trou de coulissement (3111) est pourvue d'une fente d'actionnement (311b2), et la fente d'actionnement (311b2) est une fente non circulaire.

14. Terminal à écran pliable (100) selon la revendication 13, dans lequel les directions de rotation du premier filetage externe (3112) et du second filetage externe (311b1) sont opposées l'une à l'autre.

15. Terminal à écran pliable (100) selon la revendication 3, dans lequel la première structure élastique (31) est disposée sur l'au moins une partie, et la première région de surface concave-convexe (33) est disposée sur la première surface intérieure (S1) ;
l'au moins une partie comprend en outre une seconde surface latérale (S5), la seconde surface latérale (S5) et la première surface latérale (S4) sont orientées à l'opposé l'une de l'autre, la rainure de coulissement (C) comprend en outre une seconde surface intérieure (S2), et la seconde surface intérieure (S2) et la seconde surface latérale (S5) se font face ; et
la première structure élastique (31) comprend :
une base (311), dans lequel la base (311) est disposée sur l'au moins une partie, la base (311) est pourvue d'un trou de coulissement (3111), une extrémité du trou de coulissement (3111) est ouverte pour former une première extrémité ouverte, l'autre extrémité du trou de coulissement (3111) est ouverte pour former une seconde extrémité ouverte, la première extrémité ouverte fait face à la première surface intérieure (S1), et la seconde extrémité ouverte fait face à la seconde surface intérieure (S2) ;
un deuxième élément de pression (314), dans lequel le deuxième élément de pression (314) est disposé dans le trou de coulissement (3111) et est capable de coulisser le long du trou de coulissement (3111), et une partie du deuxième élément de pression (314) fait saillie depuis la première extrémité ouverte ;
un troisième élément de pression (315), dans lequel le troisième élément de pression (315) est disposé dans le trou de coulissement (3111) et est capable de coulisser le long du trou de coulissement (3111), et une partie du troisième élément de pression (315) fait saillie depuis la seconde extrémité ouverte ; et
un second élément élastique (316), dans lequel le second élément élastique (316) est disposé dans le trou de coulissement (3111) et est situé entre le deuxième élément de pression (314) et le troisième élément de pression (315), le deuxième élément de pression (314) vient en prise avec la première région de surface concave-convexe (33), et le troisième élément de pression (315) vient en prise avec la seconde surface intérieure (S2).
